# EUROPEAN PATENT APPLICATION

(11) **EP 4 665 110 A1**
(43) Date of publication of application: **17.12.2025**
(21) Application number: 24847348.0
(22) Date of filing: 16.05.2024
(51) Int. Cl.: H10D 30/60

(54) **TRENCHED SEMICONDUCTOR STRUCTURE AND MANUFACTURING METHOD THEREFOR**

(30) Priority: 26.04.2024 CN 202410509983
(71) Applicant: Diodes Incorporated, Plano, Texas 75024 (US)
(72) Inventor: KUO, Ta-Chuan, Taiwan 231023 (CN); CHUANG, Chiao-Shun, Taiwan 231023 (CN)
(74) Representative: Marks & Clerk LLP
(86) International application number: PCT/CN2024/093540
(87) International publication number: WO 2025/222566

(57) **Abstract**

The present application relates to a trench semiconductor structure and a manufacturing method thereof. The trench semiconductor structure includes: a semiconductor material layer having a first surface, a second surface and a first conductivity type; a first trench structure extending from the first surface towards the second surface, including a first electrode and a first gate; a first doped region located in the semiconductor material layer, adjacent to the first surface and adjacent to the first portion, and having a second conductivity type; an interlayer dielectric layer located on the first surface and covering the first trench structure; a shielding metal layer covering the interlayer dielectric layer and the first doped region and contacting the first electrode; and a metal layer located on the interlayer dielectric layer and the first doped region.

## Description

### TECHNICAL FIELD

The present application relates to a trench semiconductor structure and a manufacturing method thereof, and more particularly, to a trench metal oxide semiconductor (MOS) structure and a manufacturing method thereof.

### BACKGROUND

Modem power circuits require rectifiers that provide high power, low power loss and fast switching. Integration of a trench MOS barrier Schottky (TMBS) diode and a shielded gate trench metal-oxide-semiconductor field-effect transistor (SGT MOSFET) includes placing respectively the TMBS and the SGT MOSFET in different trenches, and positioning charge coupling between a main charge carrier in the terrace-shaped portion of the epitaxial/drift region and the metal on the insulating sidewalls of a trench. The charge coupling redistributes the electric field below the Schottky contact, thereby improving the breakdown voltage and reducing the reverse leakage current. The integration of the TMBS with the SGT-MOSFET can further reduce the resistance and gate capacitance, thereby reducing the power loss of the semiconductor power circuit and increasing the switching speed of the semiconductor power circuit.

Conventional methods for integrating the TMBS and the SGT MOSFET involve placing the TMBS and the SGT-MOSFET in adjacent areas of the same chip, which requires an additional chip area. Current manufacturing methods and power circuit structures lack efficiency and flexibility, and usually cause waste of chip areas, which increases production costs. Therefore, there is a need to further improve the device miniaturization technology for semiconductor structures including TMBS and SGT MOSFET in the art, in order to achieve desirable high power and low loss, and improve device performance.

### SUMMARY

Embodiments of the present disclosure relate to a trench semiconductor structure. The trench semiconductor structure includes: a semiconductor material layer having a first surface and a second surface opposite to the first surface, wherein the semiconductor material layer has a first conductivity type; a first trench structure extending from the first surface towards the second surface, wherein the first trench structure includes a first electrode, a first gate, and a first oxide layer separating the first electrode from the first gate, the first electrode including a first portion adjacent to the first gate, and a second portion located below the first portion and the first gate and connected to the first portion; a first doped region located in the semiconductor material layer adjacent to the first surface and adjacent to the first portion of the first electrode, wherein the first doped region has a second conductivity type; an interlayer dielectric layer located on the first surface of the semiconductor material layer and covering the first trench structure; a shielding metal layer covering the interlayer dielectric layer and the first doped region and contacting the first electrode; and a metal layer located on the interlayer dielectric layer and the first doped region. The first portion of the first electrode is located between the first doped region and the first gate, and the first electrode and the first doped region are both in contact with the shielding metal layer to be electrically connected to the metal layer.

Embodiments of the present disclosure also relate to a trench semiconductor structure. The trench semiconductor structure includes: a semiconductor material layer having a first conductivity type and having a first region and a second region surrounding the first region; a first trench structure, which is recessed into the semiconductor material layer and includes a first electrode, a first gate, and a first oxide layer surrounding the first electrode and the first gate, wherein the first electrode includes a first portion adjacent to the first gate, and a second portion overlapping with the first portion and the first gate and connected to the first portion when viewed from a top view; a second trench structure, which is recessed into the semiconductor material layer and includes a second electrode, a second gate, and a second oxide layer surrounding the second electrode and the second gate; and a first doped region disposed in the semiconductor material layer and located between the first trench structure and the second trench structure, wherein the first doped region has a second conductivity type. The first electrode and the second electrode are disposed between the first gate and the second gate, a portion of the first electrode, a portion of the second electrode, and the first doped region between the first electrode and the second electrode are located in the first region, and the first gate and the second gate are located in the second region.

Embodiments of the present disclosure relate to a manufacturing method of a trench semiconductor structure. The manufacturing method of the trench semiconductor structure includes: forming a first trench in a semiconductor material layer, the first trench extending from a first surface towards a second surface; forming a first electrode in the first trench, the first electrode including a first portion and a second portion located below the first portion and connected to the first portion; forming a first gate in the first trench, the first gate being adjacent to the first portion of the first electrode and being located above the second portion of the first electrode, and the first electrode and the first gate forming a first trench structure; forming a first doped region in the semiconductor material layer adjacent to the first surface, wherein the first doped region has a second conductivity type, and the first portion of the first electrode is located between the first doped region and the first gate; forming an interlayer dielectric layer on the first surface of the semiconductor material layer, the interlayer dielectric layer covering the first trench structure and the first doped region; forming a groove extending through the interlayer dielectric layer, exposing the first doped region and the first portion of the first electrode; forming a shielding metal layer in the groove and on the interlayer dielectric layer, the shielding metal layer covering the interlayer dielectric layer and the first doped region and contacting the first portion of the first electrode; and forming a metal layer in the groove and on the interlayer dielectric layer and the shielding metal layer. The first portion of the first electrode and the first doped region are both in contact with the shielding metal layer to be electrically connected to the metal layer.

### BRIEF DESCRIPTION OF THE DRAWINGS

Aspects of several embodiments of the present disclosure may be best understood when the following detailed description is read in conjunction with the accompanying drawings. It should be noted that various structures may not be drawn to scale. In fact, the dimensions of various structures may be arbitrarily enlarged or reduced for clarity of discussion.
FIG. 1 is a top view of a trench semiconductor structure according to some embodiments of the present application;
FIG. 2 is a cross-sectional view of the trench semiconductor structure along a line AA' shown in FIG. 1 according to some embodiments of the present application;
FIG. 3 is a top view of a trench semiconductor structure according to some embodiments of the present application;
FIG. 4 is a top view of a trench semiconductor structure according to some embodiments of the present application;
FIG. 5 is a cross-sectional view of a trench semiconductor structure according to some embodiments of the present application;
FIG. 6 is a cross-sectional view of a trench semiconductor structure according to some embodiments of the present application;
FIG. 7 is a cross-sectional view of a trench semiconductor structure according to some embodiments of the present application;
FIG. 8 is a cross-sectional view of a trench semiconductor structure according to some embodiments of the present application;
FIG. 9 is a cross-sectional view of a trench semiconductor structure according to some embodiments of the present application; and
FIG. 10 to FIG. 34 show one or more stages in a method for manufacturing a trench semiconductor structure according to some embodiments of the present application.

The same or similar components are marked with the same reference numerals in the drawings and detailed description. Embodiments of the present disclosure will be readily understood from the following detailed description in conjunction with the accompanying drawings.

### DETAILED DESCRIPTION OF ILLUSTRATIVE EMBODIMENTS

The following disclosure provides many different embodiments or examples for implementing the different features of the provided subject matter. Specific examples of components and configurations are described below. Certainly, these are only examples and are not intended to be limiting. In the present disclosure, references to forming a first feature above or on a second feature may include embodiments in which the first feature and the second feature are formed to be in direct contact, and may also include embodiments in which additional features may be formed between the first feature and the second feature so that the first feature and the second feature may not be in direct contact. In addition, the present disclosure may repeat reference symbols and/or letters in various examples. This repetition is for simplicity and clarity and does not itself indicate the relationship between the various embodiments and/or configurations discussed.

The following is a detailed discussion of embodiments of the present disclosure. However, it should be understood that the present disclosure provides many applicable concepts that can be embodied in a variety of specific environments. The specific embodiments discussed are merely illustrative and do not limit the scope of the present disclosure.

The present disclosure provides a trench semiconductor structure and a manufacturing method thereof. In the trench semiconductor structure of the present disclosure, a TMBS diode is integrated with an SGT MOSFET, the distance between the TMBS and the SGT MOSFET is minimized, the chip area utilization is improved, and the chip space is saved.

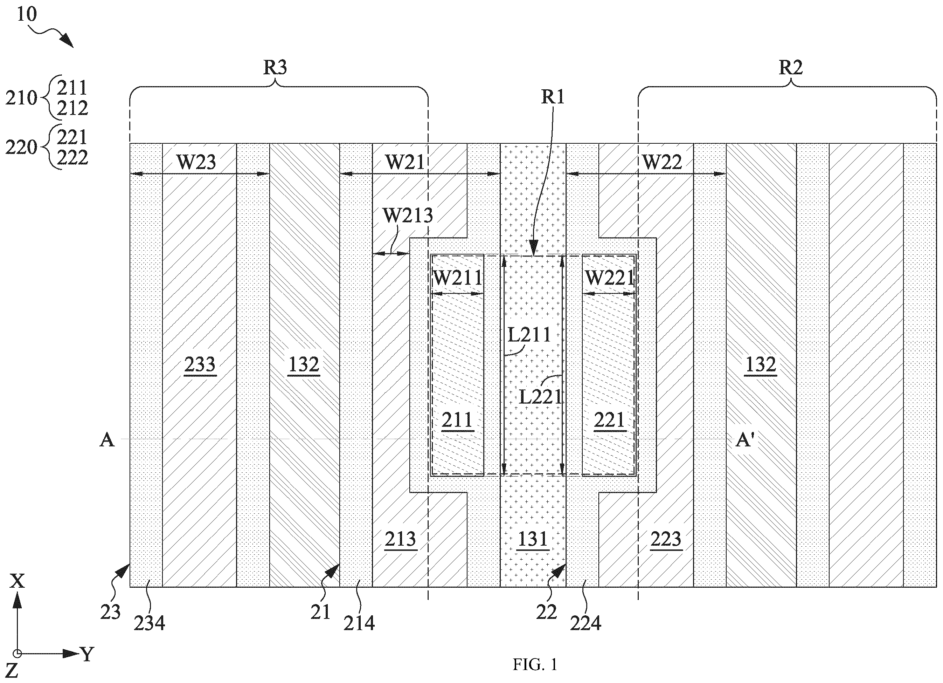

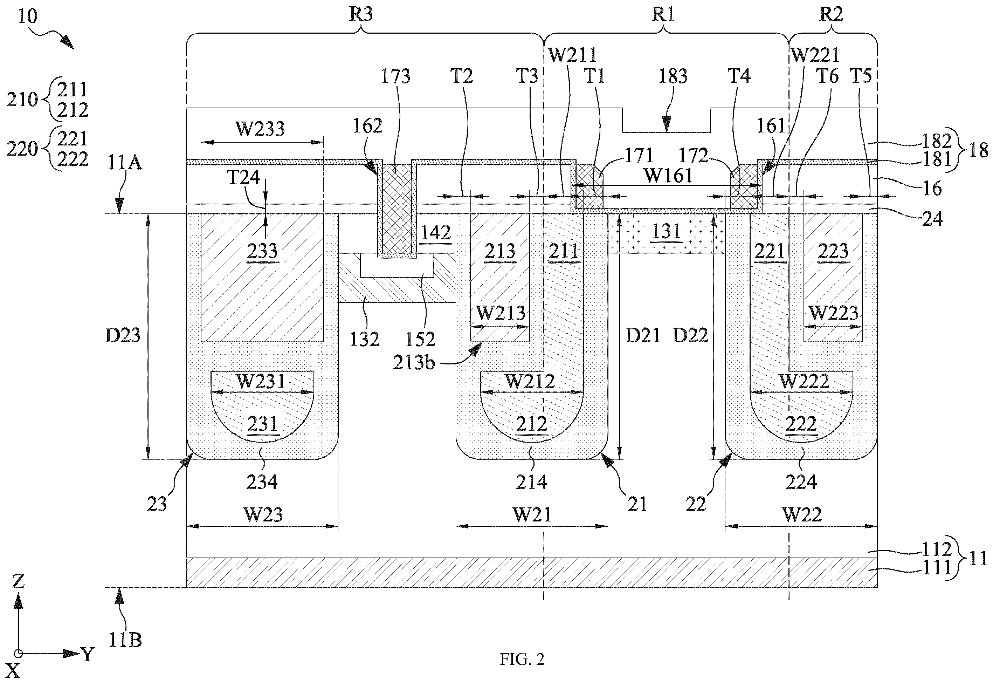

FIG. 1 is a top view of a trench semiconductor structure 10 according to some embodiments of the present application. FIG. 2 is a cross-sectional view of the trench semiconductor structure 10 along a line AA' in FIG. 1 according to some embodiments of the present application. Specifically, the trench semiconductor structure 10 is a trench MOSFET structure having a vertical current conduction path. For example, the current of the trench semiconductor structure 10 can be conducted vertically through the trench semiconductor structure 10.

In some embodiments, referring to FIG. 1 and FIG. 2, the trench semiconductor structure 10 includes a semiconductor material layer 11, a first trench structure 21, a second trench structure 22, a first doped region 131, an interlayer dielectric layer 16 and a conductive material layer 18. In some embodiments, the trench semiconductor structure 10 further includes a third trench structure 23, a second doped region 132, and a third doped region 142.

In some embodiments, the semiconductor material layer 11 includes a substrate 111 and an epitaxial layer 112 located on the substrate 111. In some embodiments, the substrate 111 includes, for example, silicon, silicon carbide (SiC), germanium (Ge), silicon germanium (SiGe), gallium nitride (GaN), gallium arsenide (GaAs), gallium arsenide phosphide (GaAsP), or other semiconductor materials. In some embodiments, the epitaxial layer 112 includes, for example, silicon, silicon carbide, germanium, silicon germanium, gallium nitride, gallium arsenide, gallium arsenide phosphide, or other semiconductor materials. The substrate 111 is an N-type or P-type semiconductor material. The epitaxial layer 112 is an N-type or P-type semiconductor material. In some embodiments, the substrate 111 and the epitaxial layer 112 have the same conductivity type, for example, the substrate 111 and the epitaxial layer 112 are both N-type.

The substrate 111 has doping of the same conductivity type as the epitaxial layer 112. In some embodiments, the substrate 111 is part of a silicon substrate or a silicon wafer. In some embodiments, the doping concentration of the substrate 111 is greater than the doping concentration of the epitaxial layer 112.

In some embodiments, the semiconductor material layer 11 is defined with a first region R1 and a second region R2 adjacent to the first region R1 viewed from the top view. The first region R1 includes a TMBS, and the second region R2 includes an SGT MOSFET. In some embodiments, the semiconductor material layer 11 is further defined with a third region R3 adjacent to the first region R1 viewed from a top view. In some embodiments, the first region R1 is located between the second region R2 and the third region R3 or is surrounded by the second region R2 and the third region R3, and the third region R3 also includes an SGT MOSFET.

The semiconductor material layer 11 may have a first surface 11A and a second surface 11B opposite to the first surface 11A. The second surface 11B and the first surface 11A may be located on opposite sides of the semiconductor material layer 11. The first surface 11A and the second surface 11B may be horizontal planes. For convenience of description, the direction perpendicular to the first surface 11A and the second surface 11B is defined as the vertical direction Z, and the plane formed by a first direction X and a second direction Y is perpendicular to the vertical direction Z. In some embodiments, the first surface 11A may be the active surface of the epitaxial layer 112. The bottom surface of the substrate 111 is the second surface 11B.

The first trench structure 21 is recessed into the semiconductor material layer 11 and extends from the first surface 11A towards the second surface 11B, where the first trench structure 21 includes a first electrode 210, a first gate 213, and a first oxide layer 214 separating the first electrode 210 from the first gate 213. The first electrode 210 includes a first portion 211 adjacent to the first gate 213, and a second portion 212 located below the first portion 211 and the first gate 213 and connected to the first portion 211. In some embodiments, the first portion 211 and the second portion 212 of the first electrode 210 are integrally formed. The first portion 211 of the first electrode 210 is located between the first gate 213 and the first doped region 131. In some embodiments, the first gate 213 is a columnar structure.

In some embodiments, the top surface of the first trench structure 21 is coplanar with the first surface 11A. In some embodiments, the top surface of the first electrode 210 and the top surface of the first gate 213 are coplanar with the first surface 11A. From the top view, the first trench structure 21 extends in the first direction X parallel to the first surface 11A, and the first portion 211 of the first electrode 210 and the first gate 213 overlap with the second portion 212 of the first electrode 210 below.

The first oxide layer 214 is used to electrically isolate the epitaxial layer 112 from the first electrode 210 and the first gate 213. In other words, the first electrode 210 and the first gate 213 are separated from the epitaxial layer 112 by the first oxide layer 214 in the trench. The first electrode 210 and the first gate 213 are respectively surrounded by the first oxide layer 214. At least a portion of the first oxide layer 214 is located between the first electrode 210 and the first gate 213. At least a portion of the first oxide layer 214 serves as a gate oxide layer of the SGT MOSFET located in the third region R3. In some embodiments, the first oxide layer 214 located between the first portion 211 of the first electrode 210 and the semiconductor material layer 11 has a first thickness T1, and the first oxide layer 214 located between the first gate 213 and the semiconductor material layer 11 has a second thickness T2, and the second thickness T2 is less than the first thickness T1. In some embodiments, the first thickness T1 and the second thickness T2 are substantially the same. The first thickness T1 and the second thickness T2 can respectively be adjusted according to the sizes of operating voltages of the first electrode 210 and the first gate 213.

In some embodiments, the first portion 211 of the first electrode 210 has a first width W211, the second portion 212 of the first electrode 210 has a second width W212, and the first width W211 is smaller than the second width W212. The first gate 213 has a third width W213, and the third width W213 is greater than or equal to the first width W211. In some embodiments, the first width W211 is substantially the same as the third width W213. In some embodiments, the second width W212 is greater than the third width W213, and the third width W213 is greater than the first width W211. In some embodiments, the sum of the first width W211 and the third width W213 is greater than or equal to the second width W212 of the second portion 212 of the first electrode 210.

The semiconductor material layer 11 includes the first doped region 131. The first doped region 131 extends in the first direction X. In some embodiments, the first doped region 131 is disposed between the first surface 11A and the second surface 11B, adjacent to the first oxide layer 214 and separated from the first electrode 210. The first doped region 131 is located in the semiconductor material layer 11 adjacent to the first surface 11A and adjacent to the first trench structure 21. In some embodiments, the first doped region 131 is located in the epitaxial layer 112 and in contact with the first oxide layer 214. At least a portion of the first oxide layer 214 is located between the first electrode 210 and the first doped region 131.

In some embodiments, the first doped region 131 serves as a doped body region of the trench semiconductor structure 10. At least a portion of the epitaxial layer 112 is disposed between the first doped region 131 and the substrate 111. In some embodiments, the first doped region 131 has a conductivity type different from that of the epitaxial layer 112, for example, having a conductivity type of a second type. In some embodiments, the first doped region 131 has a P type, while the epitaxial layer 112 has an N type. The first doped region 131 contains a P type dopant, and the P type dopant can be, for example, boron, aluminum, gallium, indium, and so on. In some embodiments, the P type dopant contained in the first doped region 131 is boron. The doping concentration of the first doped region 131 is greater than the doping concentration of the epitaxial layer 112. The depth of the first doped region 131 is less than the depth of the bottom surface 213b of the first gate 213. The first doped region 131 is electrically connected to the conductive material layer 18.

The second trench structure 22 is spaced apart from the first trench structure 21. The first doped region 131 is located between the first trench structure 21 and the second trench structure 22. The trench depth of the first trench structure 21 and the trench depth of the second trench structure 22 may be the same or different, and the trench width W21 of the first trench structure 21 and the trench width W22 of the second trench structure 22 may be the same or different. In some embodiments, the trench depth D21 of the first trench structure 21 may be the same as the trench depth D22 of the second trench structure 22. The trench width W21 of the first trench structure 21 may be the same as the trench width W22 of the second trench structure 22.

The second trench structure 22 is recessed into the semiconductor material layer 11 and extends from the first surface 11A towards the second surface 11B, where the second trench structure 22 includes a second electrode 220, a second gate 223, and a second oxide layer 224 separating the second electrode 220 from the second gate 223. The second electrode 220 includes a third portion 221 adjacent to the second gate 223, and a fourth portion 222 located below the third portion 221 and the second gate 223 and connected to the third portion 221. In some embodiments, the third portion 221 and the fourth portion 222 of the second electrode 220 are integrally formed. The third portion 221 of the second electrode 220 is located between the second gate 223 and the first doped region 131. In some embodiments, the second gate 223 is a columnar structure.

In some embodiments, the top surface of the second trench structure 22 is coplanar with the first surface 11A. In some embodiments, the top surface of the second electrode 220 and the top surface of the second gate 223 are coplanar with the first surface 11A. From the top view, the second trench structure 22 extends in the first direction X parallel to the first surface 11A, and the third portion 221 of the second electrode 220 and the second gate 223 overlap with the fourth portion 222 of the second electrode 220 below.

The second oxide layer 224 is used to electrically isolate the epitaxial layer 112 from the second electrode 220 and the second gate 223. In other words, the second electrode 220 and the second gate 223 are separated from the epitaxial layer 112 by the second oxide layer 224 in the trench. The second electrode 220 and the second gate 223 are respectively surrounded by the second oxide layer 224. At least a portion of the second oxide layer 224 is located between the second electrode 220 and the second gate 223. At least a portion of the second oxide layer 224 serves as a gate oxide layer of the SGT MOSFET located in the second region R2. In some embodiments, the second oxide layer 224 located between the third portion 221 and the semiconductor material layer 11 has a fourth thickness T4, the second oxide layer 224 located between the second gate 223 and the semiconductor material layer 11 has a fifth thickness T5, and the fifth thickness T5 is less than the fourth thickness T4. In some embodiments, the fourth thickness T4 and the fifth thickness T5 are substantially the same. The fourth thickness T4 and the fifth thickness T5 can respectively be adjusted according to the sizes or operating voltages of the second electrode 220 and the second gate 223.

In some embodiments, the third portion 221 of the second electrode 220 has a fourth width W221, and the fourth portion 222 of the second electrode 220 has a fifth width W222, and the fourth width W221 is less than the fifth width W222. The second gate 223 has a sixth width W223, and the sixth width W223 is greater than or equal to the fourth width W221. In some embodiments, the fourth width W221 is substantially the same as the sixth width W223. In some embodiments, the fifth width W222 is greater than the sixth width W223, and the sixth width W223 is greater than the fourth width W221. In some embodiments, the sum of the fourth width W221 and the sixth width W223 is greater than or equal to the fifth width W222 of the fourth portion 222 of the second electrode 220.

The trench semiconductor structure 10 includes a TMBS. In some embodiments, the TMBS is located in the first region R1, includes the first electrode 210, the second electrode 220 and the first doped region 131, and extends from the first region R1 to below the first gate 213 and the second gate 223 through the configuration of the first electrode 210 and the second electrode 220, where the first gate 213 is located in the third region R3, and the second gate 223 is located in the second region R2. The first electrode 210, the second electrode 220, and the first doped region 131 form a TMBS diode. The first portion 211 of the first electrode 210, the third portion 221 of the second electrode 220, and the first doped region 131 located between the first electrode 210 and the second electrode 220 are located in the first region R1. The first portion 211 of the first electrode 210 and the third portion 221 of the second electrode 220 are disposed between the first gate 213 and the second gate 223. From the top view, the length L211 of the first portion 211 of the first electrode 210 along the first direction X and the length L221 of the third portion 221 of the second electrode 220 along the first direction X may be the same. In some embodiments, the TMBS is surrounded by the second region R2 including the SGT MOSFET and the third region R3. The trench semiconductor structure 10 of the present application is that the TMBS and the SGT MOSFET are integrated into the first trench structure 21, where the first electrode 210 may be used as the source or shielding electrode of the TMBS, and the first gate 213 may be used as the gate of the SGT MOSFET. A portion of the first trench structure 21 belongs to the first region R1, and another portion of the first trench structure 21 belongs to the third region R3.

The semiconductor material layer 11 forms a mesa surface between the first trench structure 21 and the second trench structure 22. In some embodiments, the mesa surface separates the first trench structure 21 from the second trench structure 22. The width of the mesa surface can be controlled by the positions of the first trench structure 21 and the second trench structure 22. In some embodiments, the mesa surface is in the first region R1.

The third trench structure 23 is spaced apart from the first trench structure 21. The trench depth D21 of the first trench structure 21 and the trench depth D23 of the third trench structure 23 may be the same or different, and the trench width W21 of the first trench structure 21 and the trench width W23 of the third trench structure 23 may be the same or different. In some embodiments, the trench depth D21 of the first trench structure 21 is the same as the trench depth D23 of the third trench structure 23, and the trench width W21 of the first trench structure 21 is the same as the trench width W23 of the third trench structure 23.

The third trench structure 23 is recessed into the semiconductor material layer 11, extends from the first surface 11A towards the second surface 11B and is disposed adjacent to the first trench structure 21, where the third trench structure 23 includes a third electrode 231, a third gate 233 located over the third electrode 231, and a third oxide layer 234 separating the third electrode 231 and the third gate 233 from each other. In some embodiments, the third electrode 231 and the third gate 233 are columnar structures, respectively. In some embodiments, the top surface of the third trench structure 23 is coplanar with the first surface 11A. In some embodiments, the top surface of the third gate 233 is coplanar with the first surface 11A. From the top view, the third trench structure 23 extends in the first direction X parallel to the first surface 11A, and the third gate 233 overlaps with the third electrode 231 below.

The third oxide layer 234 is used to electrically isolate the third electrode 231 and the third gate 233 from the epitaxial layer 112. In other words, the third electrode 231 and the third gate 233 are separated from the epitaxial layer 112 via the third oxide layer 234 in the trench of the third trench structure 23. The third electrode 231 and the third gate 233 are respectively surrounded by the third oxide layer 234. At least a portion of the third oxide layer 234 is located between the third electrode 231 and the third gate 233. At least a portion of the third oxide layer 234 serves as a gate oxide layer of the SGT MOSFET located in the third region R3.

In some embodiments, the third electrode 231 has a seventh width W231, the third gate 233 has an eighth width W233, the seventh width W231 is substantially the same as the eighth width W233. In some embodiments, the seventh width W231 is smaller than the eighth width W233.

The second doped region 132 is located between the first trench structure 21 and the third trench structure 23, and extends in the first direction X. In some embodiments, the second doped region 132 is disposed between the first surface 11A and the second surface 11B, adjacent to the first oxide layer 214, and separated from the first gate 213. At least a portion of the first oxide layer 214 is located between the first gate 213 and the second doped region 132. In some embodiments, the second doped region 132 is located in the epitaxial layer 112 and contacts the first oxide layer 214 and the third oxide layer 234. The second doped region 132 is located in the semiconductor material layer 11 and adjacent to the first surface 11A, where the second doped region 132 has a second conductivity type, and the first trench structure 21 is located between the first doped region 131 and the second doped region 132.

The second doped region 132 is disposed between the first trench structure 21 and the third trench structure 23, and serves as a doped body region of the trench semiconductor structure 10. At least a portion of the epitaxial layer 112 is disposed between the second doped region 132 and the substrate 111. In some embodiments, the second doped region 132 has a conductivity type different from that of the epitaxial layer 112, for example, having a conductivity type of the second type. In some embodiments, the second doped region 132 has a P type, and the epitaxial layer 112 has an N type. The second doped region 132 includes a P type dopant, and the P type dopant can be, for example, boron, aluminum, gallium, indium, and so on. In some embodiments, the P type dopant included in the second doped region 132 is boron. The doping concentration of the second doped region 132 is greater than the doping concentration of the epitaxial layer 112. In some embodiments, the doping concentration of the second doped region 132 is different from the doping concentration of the first doped region 131. In some embodiments, the doping concentration of the second doped region 132 is greater than the doping concentration of the first doped region 131, and the doping concentration of the second doped region 132 may be, for example but not limited to, one order of magnitude greater than the doping concentration of the first doped region 131. The depth of the second doped region 132 is less than the depth of the bottom surface 213b of the first gate 213. The depth of the second doped region 132 is the same as or different from the depth of the first doped region 131. In some embodiments, the depth of the second doped region 132 is greater than the depth of the first doped region 131. The doping concentration and depth of the second doped region 132 and the doping concentration and depth of the first doped region 131 can be adjusted independently, and the forward current and reverse leakage of the TMBS of the trench semiconductor structure 10 can be controlled by adjusting the doping concentration of the first doped region 131.

The semiconductor material layer 11 further includes the third doped region 142. The third doped region 142 extends in the first direction X. In some embodiments, the third doped region 142 is located between the first surface 11A and the second doped region 132, adjacent to the first oxide layer 214 and separated from the first gate 213. The third doped region 142 is located in the semiconductor material layer 11 adjacent to the first surface 11A and adjacent to the first trench structure 21. In some embodiments, the third doped region 142 is located in the epitaxial layer 112 and in contact with the first oxide layer 214. At least a portion of the first oxide layer 214 is located between the first gate 213 and the third doped region 142.

The third doped region 142 is disposed between the first trench structure 21 and the third trench structure 23, and serves as the source of the trench semiconductor structure 10. In some embodiments, the third doped region 142 has the same conductivity type as the epitaxial layer 112, for example, having the conductivity type of the first type. In some embodiments, the third doped region 142 and the epitaxial layer 112 have the N type. The doping concentration of the third doped region 142 is greater than the doping concentration of the epitaxial layer 112. The depth of the third doped region 142 is less than the depth of the bottom surface 213b of the first gate 213. The depth of the third doped region 142 is less than the depth of the second portion 212 of the first electrode 210.

The interlayer dielectric layer 16 is located on the first surface 11A of the semiconductor material layer 11, and is used to separate the conductive material layer 18 located on the interlayer dielectric layer 16 from the semiconductor material layer 11, the first trench structure 21, the second trench structure 22, and the third trench structure 23. The interlayer dielectric layer 16 covers the first trench structure 21, the second trench structure 22, the third trench structure 23, the first doped region 131, and the third doped region 142.

In some embodiments, a fourth oxide layer 24 is located between the first surface 11A of the semiconductor material layer 11 and the interlayer dielectric layer 16. The fourth oxide layer 24 is located between the interlayer dielectric layer 16 and the first trench structure 21, the second trench structure 22, the third trench structure 23, and the third doped region 142. In some embodiments, the fourth oxide layer 24 and the first oxide layer 214, the second oxide layer 224, and the third oxide layer 234 include the same or different materials. The thickness T24 of the fourth oxide layer 24 is less than the second thickness T2 of the first oxide layer 214 located between the first gate 213 and the semiconductor material layer 11.

A first groove 161 and a second groove 162 penetrate the interlayer dielectric layer 16 and the fourth oxide layer 24. The first groove 161 is located in the first region R1, and is located over the first doped region 131, the first electrode 210 and the second electrode 220. The second groove 162 is located in the third region R3, and is located over the third doped region 142 and extends into the semiconductor material layer 11. In some embodiments, at least a portion of the first electrode 210 and at least a portion of the second electrode 220 are exposed from the first groove 161. The width of the first groove 161 is greater than the width of the second groove 162. The depth of the first groove 161 is less than the depth of the second groove 162.

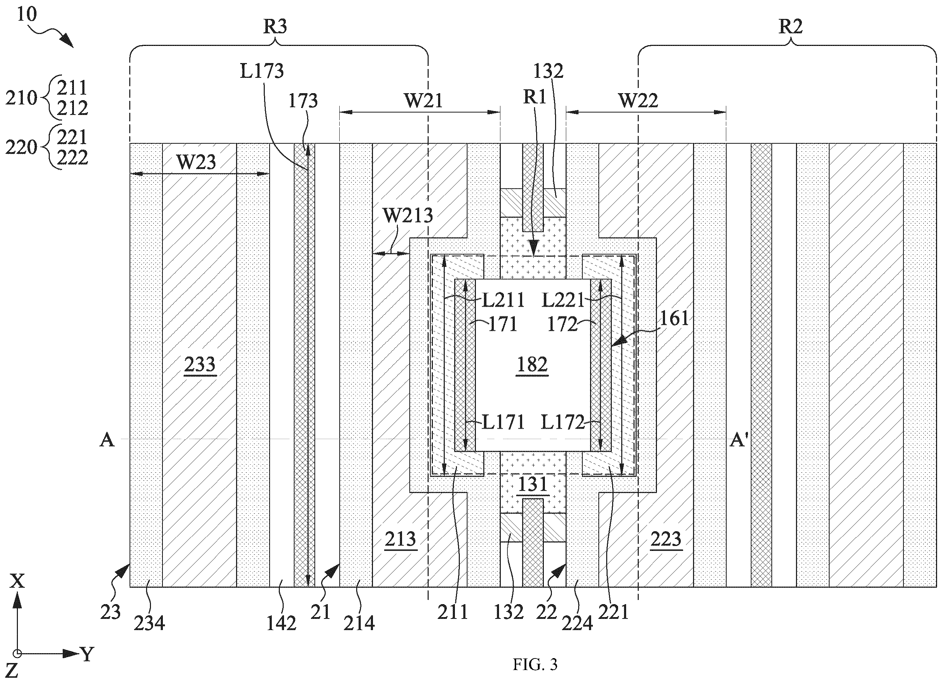

FIG. 3 is a top view of the trench semiconductor structure 10 according to some embodiments of the present application. In some embodiments, referring to FIG. 1, FIG. 2 and FIG. 3, the trench semiconductor structure 10 includes the conductive material layer 18 disposed on the interlayer dielectric layer 16 and the first doped region 131, and at least a portion of the conductive material layer 18 is disposed in the first groove 161. The first electrode 210, the second electrode 220 and the first doped region 131 are all electrically connected to the conductive material layer 18.

In some embodiments, the conductive material layer 18 may be the source of the trench semiconductor structure 10. In some embodiments, the conductive material layer 18 may be a patterned metal wire layer for adjusting the electrical path according to actual operation requirements, including a plurality of metal wires for electrically connecting to different electrodes or doped regions. In some embodiments, the conductive material layer 18 may be the first metal layer (M1) in an interconnect structure. The conductive material layer 18 includes a conductive material, such as a metal, for example but not limited to, molybdenum (Co), copper (Cu), gold (Au), silver (Ag), aluminum (Al), nickel (Ni), titanium (Ti), tungsten (W), tin (Sn), titanium nitride (TiN), aluminum silicon (AlSi) alloy, aluminum silicon copper (AlSiCu) alloy or other metals or alloys. In some embodiments, the conductive material layer 18 includes a shielding metal layer 181 and a metal layer 182 located on the shielding metal layer 181.

In some embodiments, the shielding metal layer 181 covers the interlayer dielectric layer 16 and is conformally located in the first groove 161 and the second groove 162. The shielding metal layer 181 is located between the interlayer dielectric layer 16 and the metal layer 182. The first electrode 210, the second electrode 220, and the first doped region 131 are all in contact with the shielding metal layer 181 to be electrically connected to the metal layer 182. The shielding metal layer 181 covers the interlayer dielectric layer 16, the first doped region 131, and the inner side surfaces of the first groove 161 and the second groove 162 (including the opposite sidewalls and the bottom extending between the sidewalls). The shielding metal layer 181 located in the first groove 161 contacts the interlayer dielectric layer 16, the fourth oxide layer 24, the first portion 211 of the first electrode 210, and the third portion 221 of the second electrode. The shielding metal layer 181 in the second groove 162 contacts the interlayer dielectric layer 16, the fourth oxide layer 24, the second doped region 132 and the third doped region 142. The second electrode 220 contacts the shielding metal layer 181 to be electrically connected to the metal layer 182. The shielding metal layer 181 may include molybdenum, copper or titanium.

The metal layer 182 covers the shielding metal layer 181. The first electrode 210 and the first doped region 131 are in contact with the shielding metal layer 181 and are electrically connected to the metal layer 182. In some embodiments, the metal layer 182 includes a recess 183, the recess 183 is located on the first groove 161, and the position and size of the recess 183 correspond to the position and size of the first groove 161.

In some embodiments, the shielding metal layer 181 has a notch (not shown) on the first doped region 131, and the metal layer 182 is located in the notch and contacts the first doped region 131 through the notch.

The first electrode 210, the second electrode 220 and the first doped region 131 are electrically connected to the metal layer 182, respectively. In some embodiments, a first conductive plug 171 and a second conductive plug 172 are located in the first groove 161. The first conductive plug 171 is located on the first portion 211 of the first electrode 210 and electrically connected to the first electrode 210 and the conductive material layer 18. The second conductive plug 172 is located on the third portion 221 of the second electrode 220 and electrically connected to the second electrode 220 and the conductive material layer 18. The first conductive plug 171 and the second conductive plug 172 are located on both sides of the first groove 161 and electrically connected to the first electrode 210 and the second electrode 220, respectively. The characteristics of the TMBS of the trench semiconductor structure 10, such as the magnitude of the reverse leakage current and the magnitude of the turn on voltage, and so on, depend on the concentration of the first doped region 131, the width W161 of the first groove 161, and the area of the first groove 161, viewed from the top view of FIG. 3.

The first conductive plug 171 and the second conductive plug 172 are located on the shielding metal layer 181 and separated by the metal layer 182, and at least a portion of the metal layer 182 is located between the first conductive plug 171 and the second conductive plug 172. The first conductive plug 171 and the second conductive plug 172 both penetrate the interlayer dielectric layer 16 and the fourth oxide layer 24, and are respectively adjacent to the interlayer dielectric layer 16 and the fourth oxide layer 24. The first conductive plug 171 and the second conductive plug 172 are separated from each other and both are located between the shielding metal layer 181 and the metal layer 182. The first conductive plug 171, the second conductive plug 172 and at least a portion of the metal layer 182 in the first groove 161 are surrounded by the shielding metal layer 181. In some embodiments, the first conductive plug 171 and the second conductive plug 172 include arc-shaped top surfaces. In some embodiments, the top surfaces of the first conductive plug 171 and the second conductive plug 172 are not coplanar with the top surface of the shielding metal layer 181. For example, the top surfaces of the first conductive plug 171 and the second conductive plug 172 are lower than the top surface of the shielding metal layer 181.

The first conductive plug 171 and the second conductive plug 172 are located above the first surface 11A of the semiconductor material layer 11. From the top view of FIG. 3, the first conductive plug 171 and the second conductive plug 172 are located in the first region R1 and extend in the first direction X. The length L171 of the first conductive plug 171 along the first direction X is less than the length L211 of the first electrode 210 along the first direction X. The length L172 of the second conductive plug 172 along the first direction X is less than the length L221 of the second electrode 220 along the first direction X.

The second doped region 132 is electrically connected to the metal layer 182. In some embodiments, a third conductive plug 173 is located in the second groove 162 and electrically connected to the second doped region 132 and the metal layer 182. The third conductive plug 173 penetrates the interlayer dielectric layer 16 and the fourth oxide layer 24, and is surrounded by the shielding metal layer 181. The third conductive plug 173 extends from above the first surface 11A of the semiconductor material layer 11 towards the second surface 11B along the vertical direction Z. The first gate 213, the third electrode 231, the third gate 233, the second doped region 132, the third doped region 142 and the third conductive plug 173 form a SGT MOSFT. In some embodiments, the top surface of the third conductive plug 173 is not coplanar with the top surface of the shielding metal layer 181, for example, the top surface of the third conductive plug 173 is lower than the top surface of the shielding metal layer 181. From the top view of FIG. 3, the third conductive plug 173 is located in the third region R3 and extends in the first direction X. The length L171 of the first conductive plug 171 along the first direction X is smaller than the length L173 of the third conductive plug 173 along the first direction X.

A heavily doped region 152 is located in the second doped region 132. The heavily doped region 152 has the same conductivity type as the second doped region 132, for example, a P type. In some embodiments, the doping concentration of the heavily doped region 152 is greater than the doping concentration of the second doped region 132. In some embodiments, the heavily doped region 152 is located in the second doped region 132 and is separated from the first oxide layer 214 and the third oxide layer 234. In some embodiments, the heavily doped region 152 is disposed between the adjacent second doped region 132 and the third doped region 142. The heavily doped region 152 is located below the third conductive plug 173, a portion of the heavily doped region 152 is located between the third conductive plug 173 and the first trench structure 21, and another portion of the heavily doped region 152 is located between the third conductive plug 173 and the third trench structure 23. In other words, the heavily doped region 152 surrounds the bottom of the third conductive plug 173 disposed in the second doped region 132 to reduce the ohmic contact resistance.

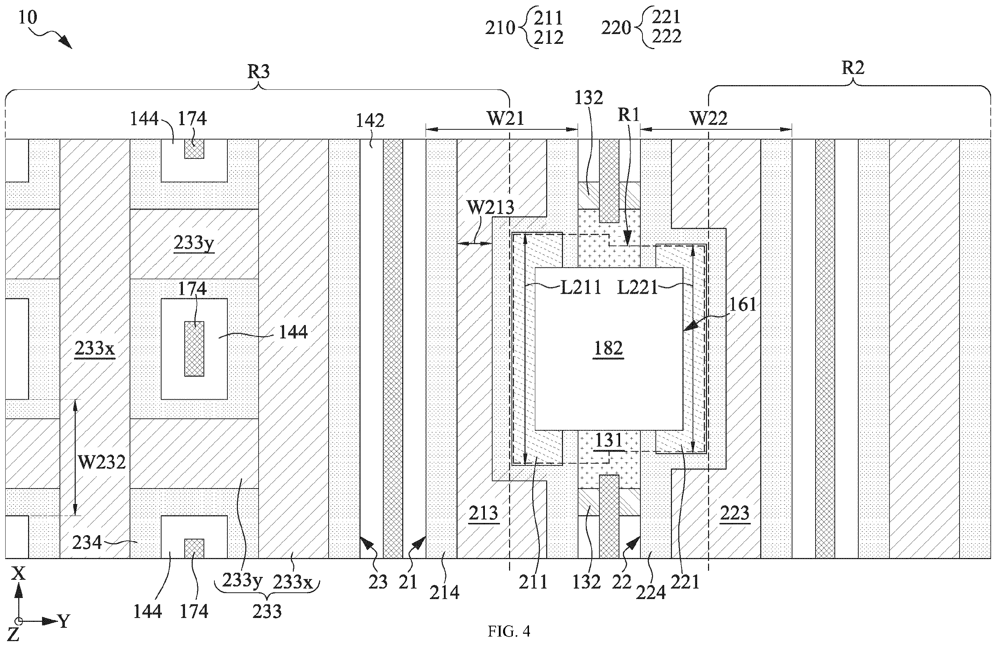

FIG. 4 is a top view of the trench semiconductor structure 10 according to some embodiments of the present application. In some embodiments, referring to FIG. 4, from the top view of FIG. 4, the third gate 233 has a mesh structure. The third gate 233 includes a fifth portion 233x extending along the first direction X and a sixth portion 233y extending along the second direction Y different from the first direction X. In some embodiments, the third gate 233 includes a plurality of fifth portions 233x and a plurality of sixth portions 233y. In some embodiments, the first direction X is orthogonal to the second direction Y.

In some embodiments, a plurality of fourth doped regions 144 are disposed in the mesh structure, and each fourth doped region 144 is surrounded by the fifth portion 233x and the sixth portion 233y of the third gate 233 and by the third oxide layer 234. Each fourth doped region 144 is electrically connected to the metal layer 182. In some embodiments, the trench semiconductor structure 10 includes a plurality of fourth conductive plugs 174 corresponding to the plurality of fourth doped regions 144, and each fourth doped region 144 is electrically connected to the metal layer 182 by a corresponding fourth conductive plug 174.

In some embodiments, the length L211 of the first portion 211 of the first electrode 210 along the first direction X and the length L221 of the third portion 221 of the second electrode 220 along the first direction X may be different. For example, the length L211 is greater than the length L221.

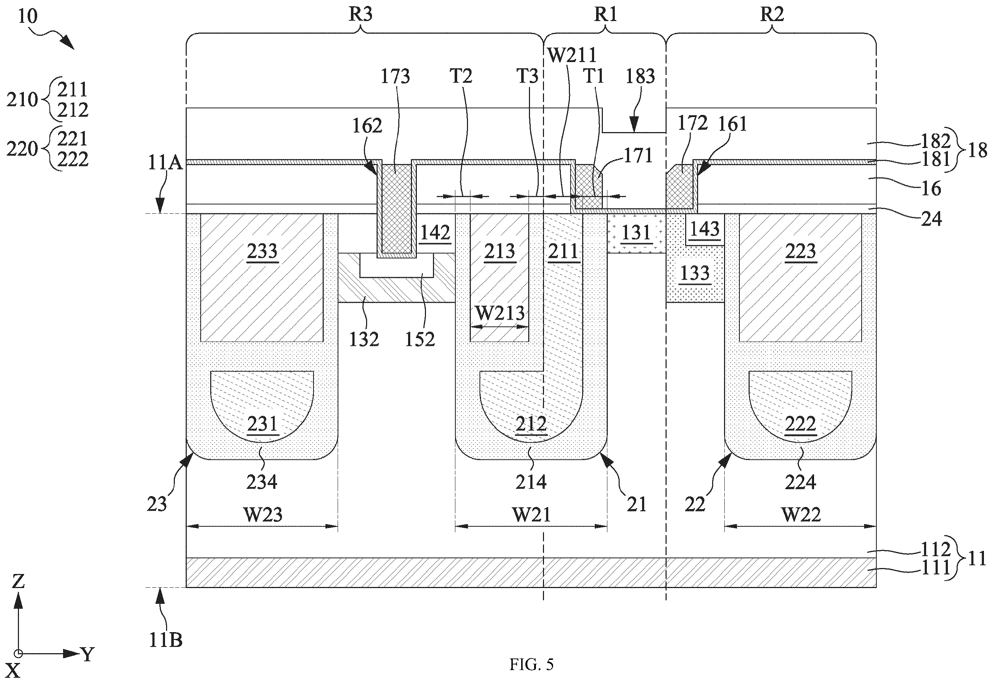

FIG. 5 is a cross-sectional view of the trench semiconductor structure 10 according to some embodiments of the present application. In some embodiments, a portion of the mesa surface between the first trench structure 21 and the second trench structure 22 belongs to the first region R1, and the second trench structure 22 and the remaining portion of the mesa surface belong to the second region R2. In some embodiments, the second electrode 220 is located below the second gate 223, and the second electrode 220 has only the fourth portion 222. In some embodiments, the structure of the TMBS is asymmetric, and may be a single-sided structure as shown in FIG. 5. A portion of the mesa surface between the first trench structure 21 and the second trench structure 22 belongs to the TMBS, and another portion belongs to the SGT MOSFET. Compared with the trench semiconductor structure 10 shown in FIGs. 1-3, the TMBS of the trench semiconductor structure 10 shown in FIG. 5 only occupies a portion of the mesa surface between the first trench structure 21 and the second trench structure 22, and thus the leakage of the TMBS is reduced and the driving voltage is increased. At the same time, the channel space of the SGT MOSFET is increased, so that the on-resistance (Ron) of the SGT MOSFET is reduced.

In some embodiments, when the first doped region 131 of the trench semiconductor structure 10 shown in FIGs. 1-3 and the trench semiconductor structure 10 shown in FIG. 5 have substantially the same doping concentration, the driving voltages of the TMBS of the trench semiconductor structure 10 shown in FIGs.1-3 and the trench semiconductor structure 10 shown in FIGs.5 may be 0.3V and 0.35V, respectively.

A fifth doped region 133 and the first doped region 131 are located between the first trench structure 21 and the second trench structure 22, and serve as the doped body region of the trench semiconductor structure 10. The fifth doped region 133 is located between the first doped region 131 and the second trench structure 22. In some embodiments, the fifth doped region 133 is disposed between the first surface 11A and the second surface 11B, adjacent to the second oxide layer 224, and separated from the second gate 223. At least a portion of the second oxide layer 224 is located between the second gate 223 and the fifth doped region 133. In some embodiments, the fifth doped region 133 is located in the epitaxial layer 112 and in contact with the second oxide layer 224. The fifth doped region 133 is located in the semiconductor material layer 11 and adjacent to the first surface 11A, where the fifth doped region 133 has the second conductivity type, and the first doped region 131 is located between the first trench structure 21 and the fifth doped region 133.

At least a portion of the epitaxial layer 112 is disposed between the fifth doped region 133 and the substrate 111. In some embodiments, the fifth doped region 133 has a conductivity type different from that of the epitaxial layer 112, for example, having a conductivity type of the second type. In some embodiments, the fifth doped region 133 has a P type, and the epitaxial layer 112 has an N type. The fifth doped region 133 includes a P type dopant, and the P type dopant may be, for example, boron, aluminum, gallium, indium, and so on. In some embodiments, the P type dopant included in the fifth doped region 133 is boron. The doping concentration of the fifth doped region 133 is greater than the doping concentration of the epitaxial layer 112. In some embodiments, the doping concentration of the fifth doped region 133 is different from the doping concentration of the first doped region 131. In some embodiments, the doping concentration of the fifth doped region 133 is greater than the doping concentration of the first doped region 131, for example, but not limited to, the doping concentration of the fifth doped region 133 is one order of magnitude greater than the doping concentration of the first doped region 131. In some embodiments, the doping concentration of the fifth doped region 133 is substantially the same as the doping concentration of the second doped region 132.

The depth of the fifth doped region 133 is less than the depth of the bottom surface 213b of the first gate 213. The depth of the fifth doped region 133 is the same as or different from the depth of the first doped region 131. In some embodiments, the depth of the fifth doped region 133 is greater than the depth of the first doped region 131. The depth of the fifth doped region 133 is the same as or different from the depth of the second doped region 132. In some embodiments, the depth of the fifth doped region 133 is substantially the same as the depth of the second doped region 132.

The semiconductor material layer 11 further includes a sixth doped region 143. The fifth doped region 133 and the sixth doped region 143 are located in the second region R2 between the first trench structure 21 and the second trench structure 22. The sixth doped region 143 extends in the first direction X. In some embodiments, the sixth doped region 143 is located between the first surface 11A and the fifth doped region 133, adjacent to the second oxide layer 224 and separated from the second gate 223. The sixth doped region 143 is located in the semiconductor material layer 11 adjacent to the first surface 11A and adjacent to the second trench structure 22. In some embodiments, the sixth doped region 143 is located in the epitaxial layer 112 and in contact with the second oxide layer 224. At least a portion of the second oxide layer 224 is located between the second gate 223 and the sixth doped region 143.

The sixth doped region 143 is disposed between the second trench structure 22 and the fifth doped region 133, and serves as the source of the trench semiconductor structure 10. In some embodiments, the sixth doped region 143 has the same conductivity type as the epitaxial layer 112, for example, the first conductivity type. In some embodiments, the sixth doped region 143 and the epitaxial layer 112 have N-type. The doping concentration of the sixth doped region 143 is greater than the doping concentration of the epitaxial layer 112. The depth of the sixth doped region 143 is less than the depth of the bottom surface 213b of the first gate 213. The depth of the sixth doped region 143 is less than the depth of the fifth doped region 133. The shielding metal layer 181 contacts the fifth doped region 133 and the sixth doped region 143.

In some embodiments, the TMBS is located in the first region, and the first electrode 210, the first doped region 131 and the first conductive plug 171 form the TMBS in the first region R1. The second gate 223, the second electrode 220, the fifth doped region 133, the sixth doped region 143 and the second conductive plug 172 form the SGT MOSFT in the second region R2. In some embodiments, by adjusting the relative doping concentrations of the fifth doped region 133 and the sixth doped region 143, the sixth doped region 143 has a relatively high doping concentration, and the current of the SGT MOSFT does not flow from the sixth doped region 143 to the second conductive plug 172.

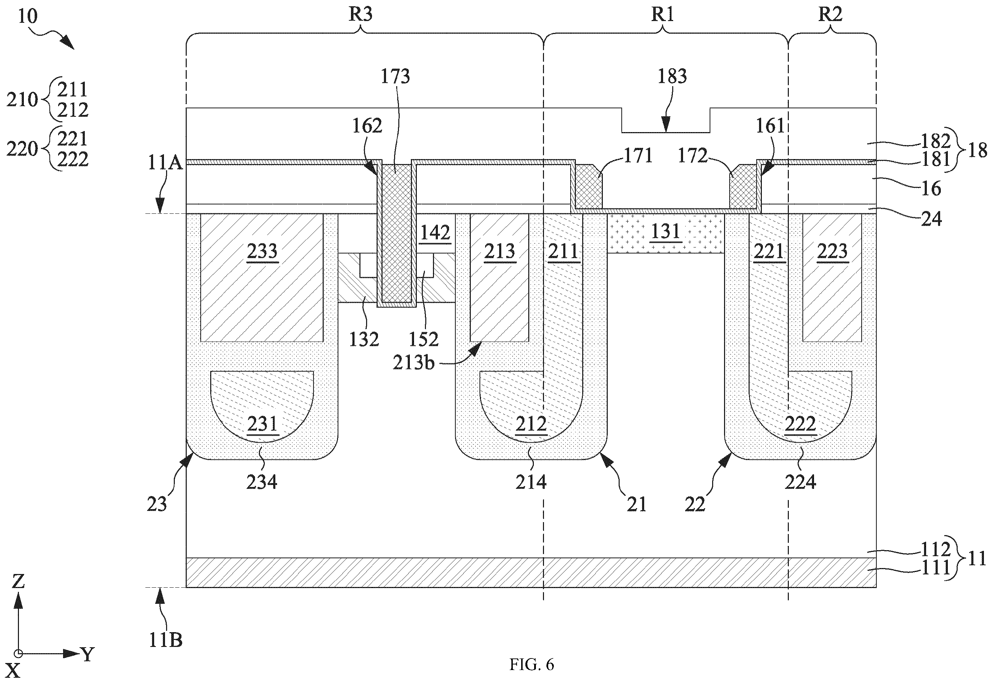

FIG. 6 is a cross-sectional view of the trench semiconductor structure 10 according to some embodiments of the present application. In some embodiments, referring to FIG. 6, the shielding metal layer 181 and the third conductive plug 173 in the second groove 162 penetrate through the second doped region 132 and the heavily doped region 152. The heavily doped region 152 surrounds at least a portion of the shielding metal layer 181 and at least a portion of the third conductive plug 173. The bottom of the shielding metal layer 181 and the third conductive plug 173 are located in the epitaxial layer 112, and the bottom of the shielding metal layer 181 and the third conductive plug 173 contact the epitaxial layer 112 having the first conductivity type, forming a Schottky contact area. Compared with the trench semiconductor structure 10 shown in FIGs. 1-3, the Schottky contact area of the third region R3 of the trench semiconductor structure 10 shown in FIG. 6 is increased, thereby reducing the turn on voltage and increasing the possibility of reverse leakage.

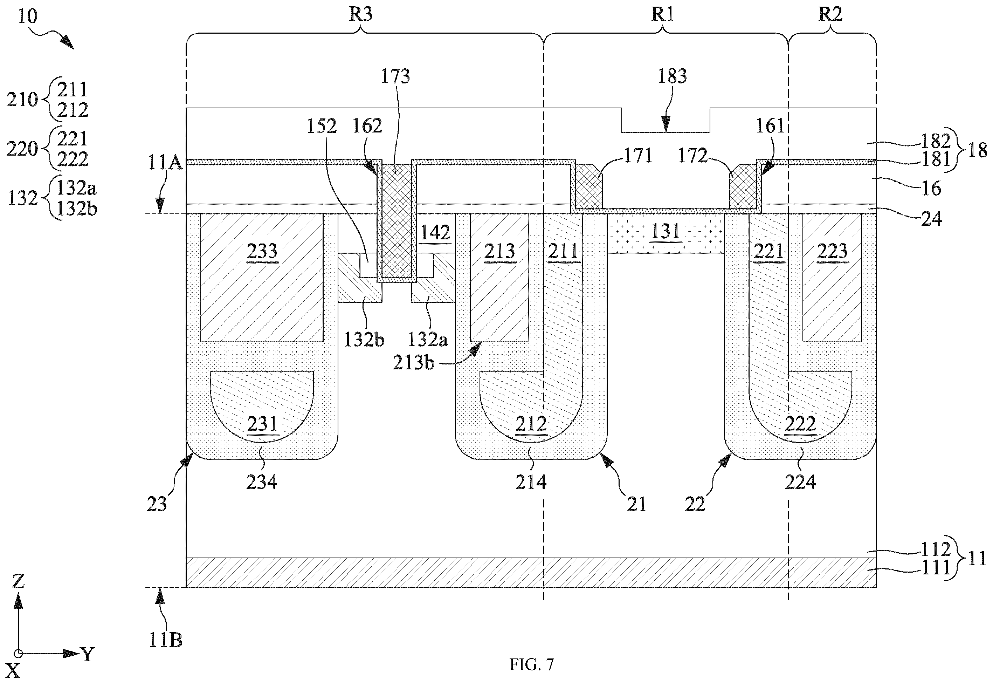

FIG. 7 is a cross-sectional view of the trench semiconductor structure 10 according to some embodiments of the present application. In some embodiments, referring to FIG. 7, the shielding metal layer 181 and the third conductive plug 173 in the second groove 162 penetrate through the heavily doped region 152, and the heavily doped region 152 surrounds at least a portion of the shielding metal layer 181 and at least a portion of the third conductive plug 173. The second doped region 132 surrounds at least a portion of the sidewalls of the shielding metal layer 181 and at least a portion of the sidewalls of the third conductive plug 173, the shielding metal layer 181 and the bottom of the third conductive plug 173 are located in the epitaxial layer 112, and the bottom of the third conductive plug 173 contacts the epitaxial layer 112 having the first conductivity type, forming a Schottky contact area. Compared with the trench semiconductor structure 10 shown in FIGs. 1-3, the Schottky contact area of the third region R3 of the trench semiconductor structure 10 shown in FIG. 7 is increased, thereby reducing the turn on voltage and increasing the possibility of leakage.

In some embodiments, the second doped region 132 includes a first sub-region 132a and a second sub-region 132b separated from each other, the first sub-region 132a contacts the first trench structure 21 and the shielding metal layer 181, the second sub-region 132b contacts the second trench structure 22 and the shielding metal layer 181, and the third conductive plug 173 is located between the first sub-region 132a and the second sub-region 132b separated from each other. The depth of the bottom of the first sub-region 132a and the depth of the bottom of the second sub-region 132b are greater than the depth of the bottom of the third conductive plug 173. The depth of the bottom of the third conductive plug 173 of the trench semiconductor structure 10 shown in FIG. 7 is less than the depth of the bottom of the second doped region 132. Because the second doped region 132 includes the first sub-region 132a and the second sub-region 132b separated from each other, the bottoms of the shielding metal layer 181 and the third conductive plug 173 contact the epitaxial layer 112, thereby forming a Schottky contact area. Comparing FIG. 6 and FIG. 7, the different bottom depths of the shielding metal layer 181 and the third conductive plug 173 result in different Schottky contact areas in the third region R3. The Schottky contact area affects the turn on voltage and reverse leakage, and the bottom depth of the third conductive plug 173 can be adjusted according to the required properties of the trench semiconductor structure 10.

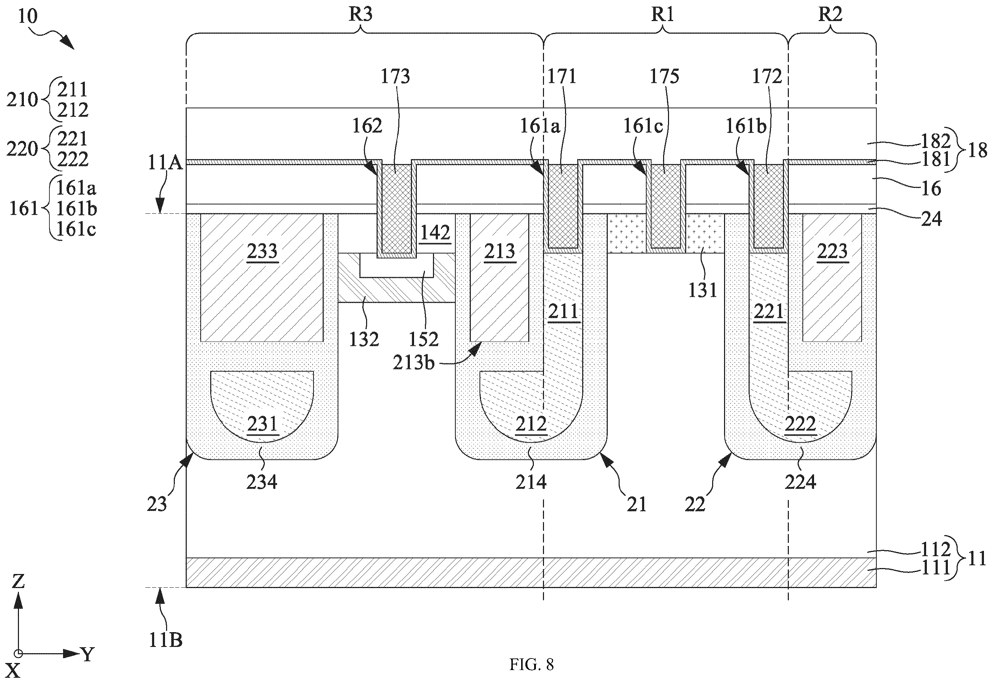

FIG. 8 is a cross-sectional view of the trench semiconductor structure 10 according to certain embodiments of the present application. In some embodiments, the first groove 161 includes a block 161a, a block 161b, and a block 161c, and the shielding metal layer 181 is conformally located in the block 161a, the block 161b, and the block 161c. The first conductive plug 171 and the second conductive plug 172 are respectively located in the block 161a and the block 161b. A fifth conductive plug 175 is located in the block 161c. The metal layer 182 is located on the first conductive plug 171, the second conductive plug 172, and the fifth conductive plug 175. The shielding metal layer 181 surrounds the first conductive plug 171, the second conductive plug 172 and the fifth conductive plug 175. The fifth conductive plug 175 is electrically connected to the shielding metal layer 181, the metal layer 182 and the first doped region 131. In some embodiments, the first conductive plug 171, the second conductive plug 172 and the fifth conductive plug 175 penetrate the interlayer dielectric layer 16 and the fourth oxide layer 24, respectively. The fifth conductive plug 175 extends from above the first surface 11A of the semiconductor material layer 11 towards the second surface 11B along the vertical direction Z. When the first groove 161 includes the independent blocks 161a, 161b, and 161c, instead of an integral groove, the metal layer 182 will not have the recess 183.

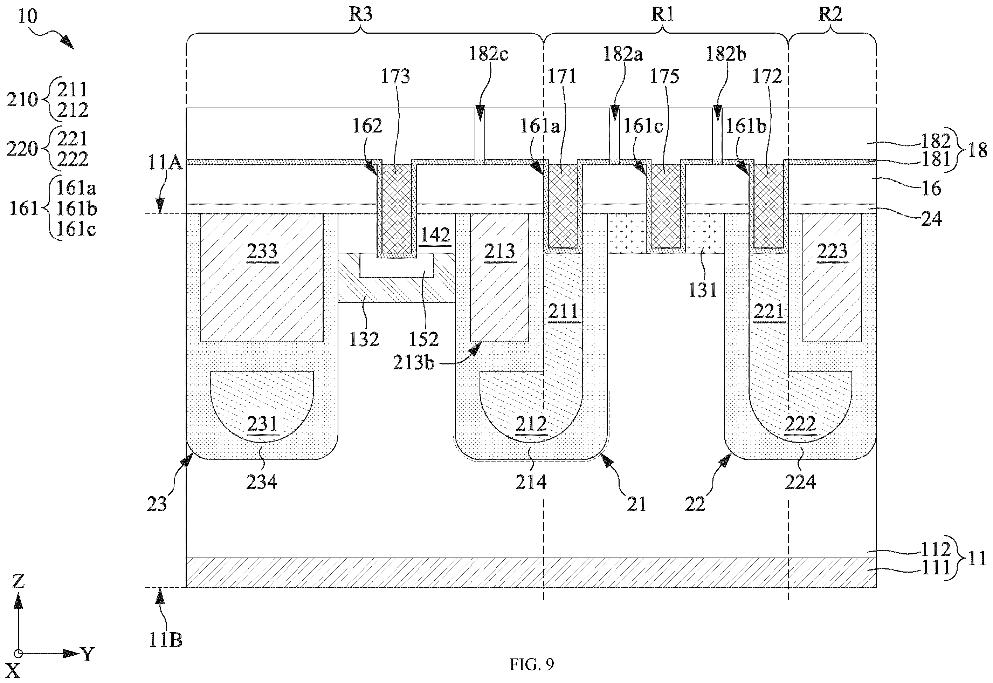

FIG. 9 is a cross-sectional view of the trench semiconductor structure 10 according to some embodiments of the present application. In some embodiments, openings 182a, 182b, and 182c penetrate the conductive material layer 18. The openings 182a, 182b, and 182c penetrate the shielding metal layer 181 and the metal layer 182 to expose the interlayer dielectric layer 16 from the openings 182a, 182b, and 182c. In some embodiments, the openings 182a and 182b are disposed on the first groove 161, and the opening 182c is disposed on the first trench structure 21. In some embodiments, the metal layer 182 between the openings 182a and 182b and the metal layer 182 on the third conductive plug 173 are used respectively as sources. The metal layer 182 between the openings 182a and 182c and the metal layer 182 on the second conductive plug 172 are respectively used as the gate, and the source or floating electrode. In some embodiments, when the metal layer 182 between the opening 182a and the opening 182c serves as the gate and is electrically connected to the first conductive plug 171, positive charges are accumulated on the first electrode 210, and electrons are adsorbed to the interface between the bottom of the first trench structure 21 and the epitaxial layer 112 (as shown by the dotted line), causing the on-resistance of the SGT MOSFET decreases and the capacitance from the drain to the gate increases, which is suitable to be applied in the trench semiconductor structure 10 with a lower switching speed.

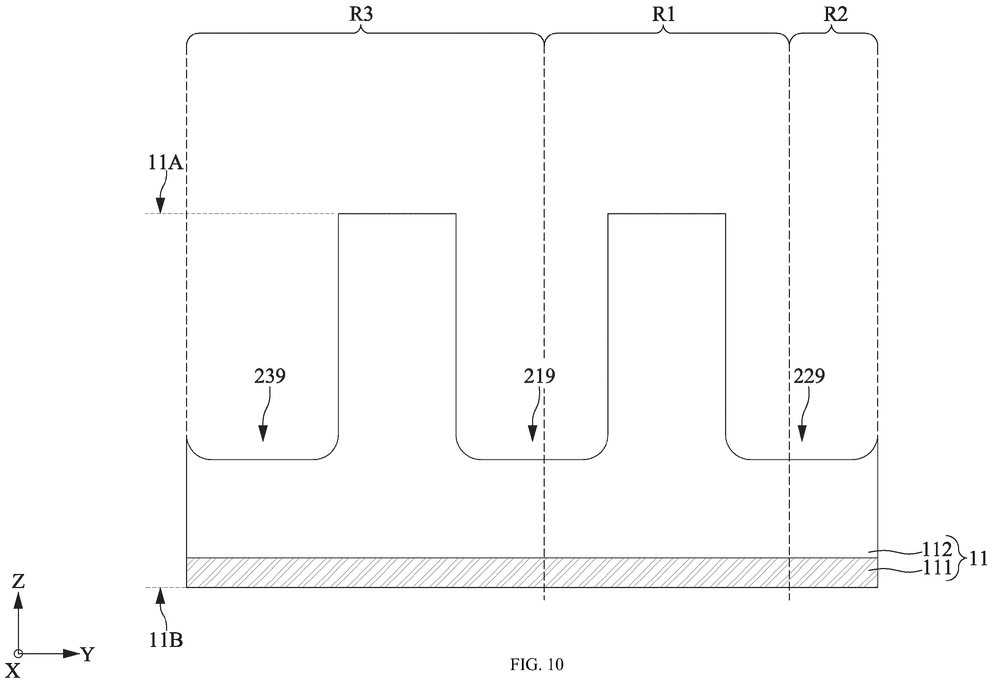

FIG. 10 to FIG. 34 illustrate one or more stages in a manufacturing method of a trench semiconductor structure according to some embodiments of the present application. At least some of these figures have been simplified to facilitate a better understanding of aspects of the present disclosure.

Referring to FIG. 10, a semiconductor material layer 11 may include a substrate 111 and an epitaxial layer 112 located on the substrate 111. The manufacturing method includes performing epitaxial growth on the substrate 111 to form the epitaxial layer 112. The epitaxial layer 112 has a first surface 11A of the semiconductor material layer 11, the substrate 111 has a second surface 11B of the semiconductor material layer 11, and the first surface 11Ais opposite to the second surface 11B. In some embodiments, ion implantation is performed simultaneously with the epitaxial growth, and ions with N-type electrical properties are implanted to form an N-type epitaxial layer 112.

A first patterned shielding layer (not shown) may be formed on the epitaxial layer 112 to define positions of a first trench 219, a second trench 229 and a third trench 239 as shown in FIG. 10, and an etching process (e.g., a plasma dry etching process) may be performed to the epitaxial layer 112 through the first patterned shielding layer to form the first trench 219, the second trench 229 and the third trench 239 at intervals. An etching process removes the epitaxial layer 112 from the first surface 11A and stops in the epitaxial layer 112. According to the positions defined by the first patterned shielding layer, the first trench 219, the second trench 229 and the third trench 239 are formed at intervals in the semiconductor material layer 11 along the first direction X and extend from the first surface 11A towards the second surface 11B opposite to the first surface 11A. Part of the first trench 219 and part of the second trench 229 are formed in a first region R1 of the semiconductor material layer 11, part of the second trench 229 is formed in a second region R2 of the semiconductor material layer 11, and the third trench 239 is formed in a third region R3 of the semiconductor material layer 11. The first region R1 is located between the second region R2 and the third region R3.

In some embodiments, the first groove 219, the second groove 229 and the third groove 239 may have vertical sidewalls. The first groove 219, the second groove 229 and the third groove 239 may have arc-shaped bottom surfaces. In addition, the first groove 219, the second groove 229 and the third groove 239 may be circular, elliptical, rectangular or polygonal. In some embodiments, the first groove 219, the second groove 229 and the third groove 239 have the same width. In some embodiments, the first groove 219, the second groove 229 and the third groove 239 have the same depth.

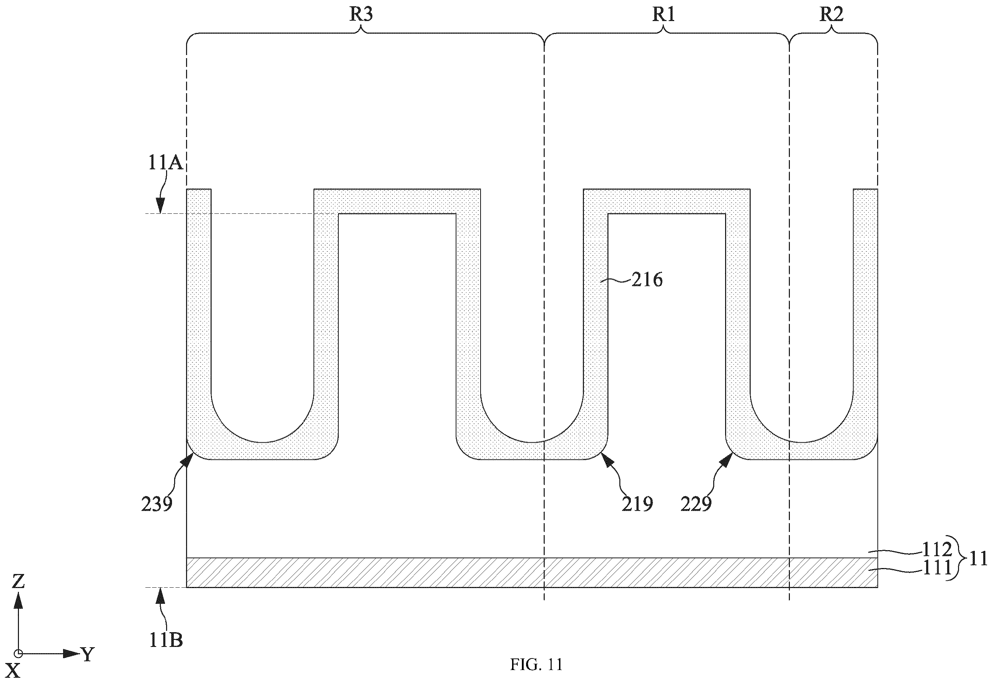

Referring to FIG. 11, the manufacturing method includes forming a first in-trench oxide layer 216 in the first trench 219, the second trench 229 and the third trench 239. In some embodiments, the first in-trench oxide layer 216 covers the first surface 11A. In some embodiments, the first in-trench oxide layer 216 may be formed by thermal oxidation technology or other deposition processes, and the deposition process may be, for example, atomic layer deposition (ALD), chemical vapor deposition (CVD), or other deposition methods. In some embodiments, the first in-trench oxide layer 216 may be conformally deposited on the inner side surfaces (including the opposite sidewalls and the bottom extending between the sidewalls) of the first trench 219, the second trench 229 and the third trench 239. In some embodiments, the first in-trench oxide layer 216 may be filled into the first trench 219, the second trench 229, and the third trench 239 through a deposition process, such that the first in-trench oxide layer 216 forms at least one groove in the first trench 219, the second trench 229 and the third trench 239, respectively. In some embodiments, the portion of the first in-trench oxide layer 216 in the first trench 219 is a first oxide layer 214, the portion of the first in-trench oxide layer 216 in the second trench 229 is a second oxide layer 224, and the portion of the first in-trench oxide layer 216 in the third trench 239 is a third oxide layer 234. The first oxide layer 214, the second oxide layer 224, and the third oxide layer 234 may be formed simultaneously.

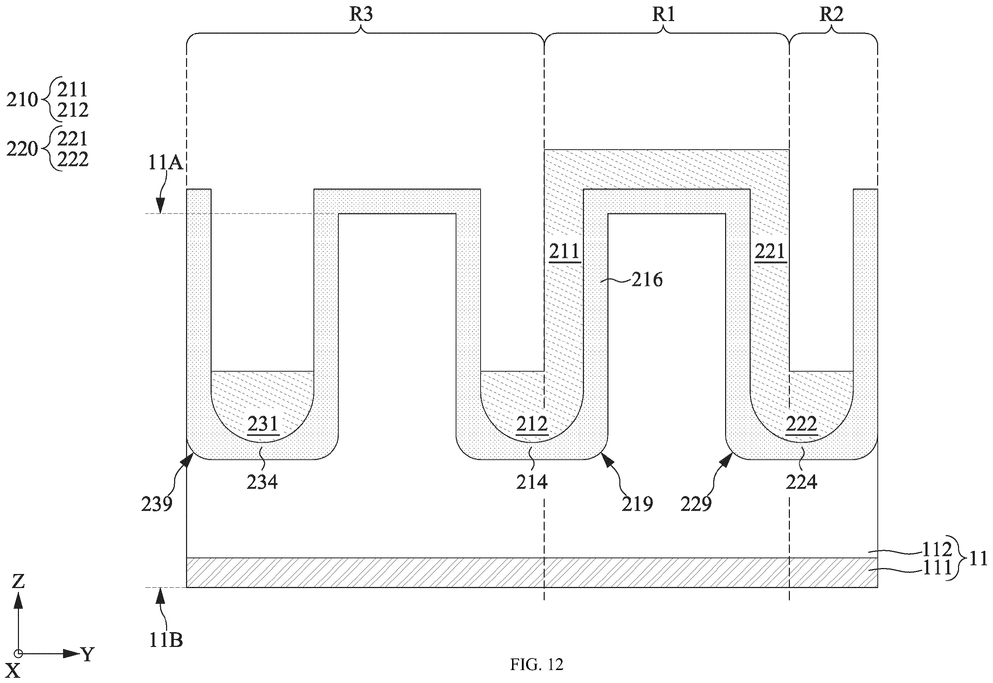

Referring to FIG. 12, the manufacturing method includes forming a first electrode 210, a second electrode 220 and a third electrode 231 in the first trench 219, the second trench 229, and the third trench 239, respectively. The first electrode 210, the second electrode 220, and the third electrode 231 may be formed simultaneously. The first portion 211 and the second portion 212 of the first electrode 210 are formed simultaneously. The third portion 221 and the fourth portion 222 of the second electrode 220 are formed simultaneously.

In some embodiments, the first electrode 210 is disposed in the first trench 219 and on the top surface of the first oxide layer 214, the second electrode 220 is disposed in the second trench 229 and on the top surface of the second oxide layer 224, and the third electrode 231 is disposed in the third trench 239 and on the top surface of the third oxide layer 234. The top surface of the second portion 212 of the first electrode 210, the top surface of the fourth portion 222 of the second electrode 220, and the top surface of the third electrode 231 may be coplanar. The first portion 211 of the first electrode 210 and the third portion 221 of the second electrode 220 extend onto the first surface 11A and are connected to each other.

The first in-trench oxide layer 216 may surround the first electrode 210, the second electrode 220 and the third electrode 231. In some embodiments, the first electrode 210, the second electrode 220 and the third electrode 231 may be formed by physical vapor deposition (PVD), e.g., sputtering or spraying of a semiconductor material or electrode material. In some embodiments, the first electrode 210, the second electrode 220 and the third electrode 231 may be formed by electroplating or CVD of a semiconductor material or electrode material. In some embodiments, the semiconductor material or electrode material may cover the first in-trench oxide 216, and then an etching process is performed to remove the semiconductor material or electrode material outside the first trench 219, the second trench 229 and the third trench 239 by methods such as dry etching to form the first electrode 210, the second electrode 220 and the third electrode 231. In some embodiments, the semiconductor material or electrode material includes polysilicon.

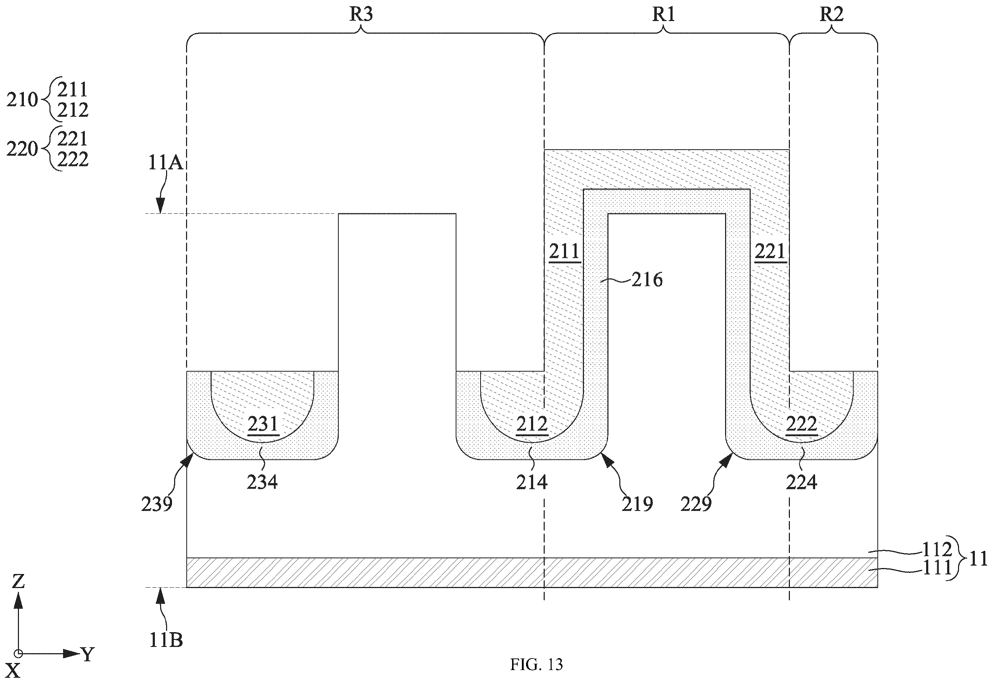

Referring to FIG. 13, the manufacturing method includes removing a portion of the first in-trench oxide layer 216 in the first trench 219, the second trench 229 and the third trench 239, so as to expose a portion of the inner side surfaces of the first trench 219 and the second trench 229, and the inner side surfaces of the third trench 239. In some embodiments, the manufacturing method includes removing the first in-trench oxide layer 216 in the first trench 219 that is not in contact with the first electrode 210, removing the first in-trench oxide layer 216 in the second trench 229 that is not in contact with the second electrode 220, and removing a portion of the first in-trench oxide layer 216 in the third trench 239 that is not in contact with the third electrode 231. In some embodiments, after removing portions of the first in-trench oxide layer 216 in the first trench 219, the second trench 229 and the third trench 239, the first trench 219 includes the first electrode 210 and the first oxide layer 214 in contact with the first electrode 210, the second trench 229 includes the second electrode 220 and the second oxide layer 224 in contact with the second electrode 220, and the third trench 239 includes the third electrode 231 located at the bottom of the third trench 239 and the third oxide layer 234 surrounding the third electrode 231.

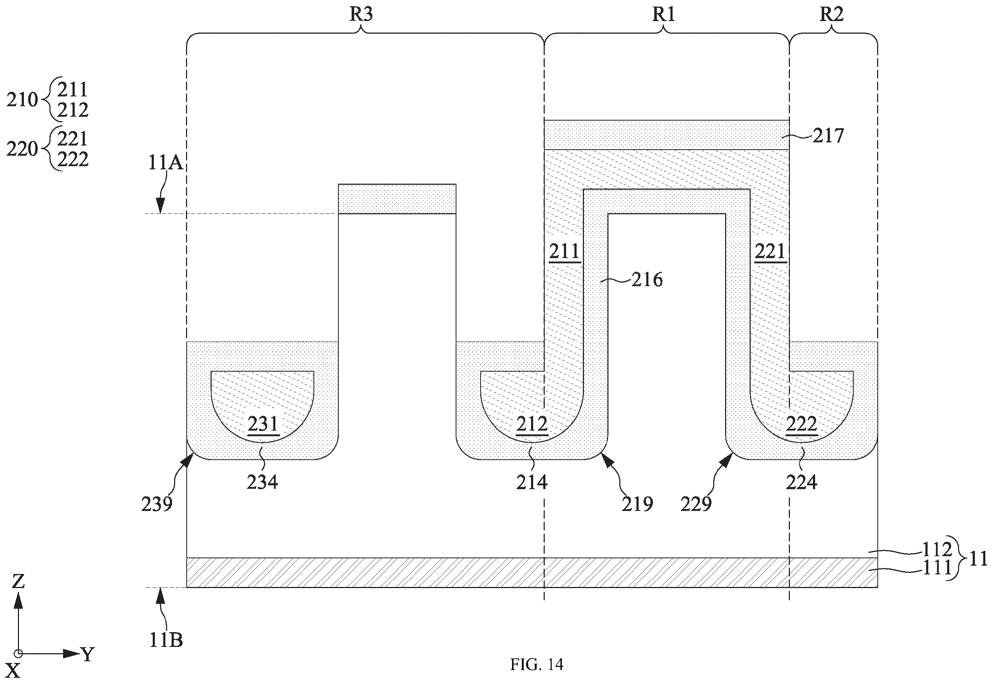

Referring to FIG. 14, the manufacturing method includes forming a second in-trench oxide layer 217 in the first trench 219, the second trench 229 and the third trench 239. In some embodiments, the second in-trench oxide layer 217 covers the first electrode 210, the second electrode 220, the third electrode 231, and the first surface 11A. In some embodiments, the second in-trench oxide layer 217 may be formed by thermal oxidation technology or other deposition processes. In some embodiments, the second in-trench oxide layer 217 may be filled into the first trench 219, the second trench 229 and the third trench 239 by a deposition process, so that the second in-trench oxide layer 217 is conformally deposited on the first electrode 210 in the first trench 219, the second electrode 220 in the second trench 229, and the third electrode 231 in the third trench 239, respectively. In some embodiments, the second in-trench oxide layer 217 may be formed by an anisotropic deposition process. In some embodiments, the second in-trench oxide layer 217 may be used as a sacrificial structure and will be removed in a subsequent step so that the surface exposed after removing the second in-trench oxide layer 217 has better quality, e.g., being smoother, which is conducive to forming other structures on the exposed surface.

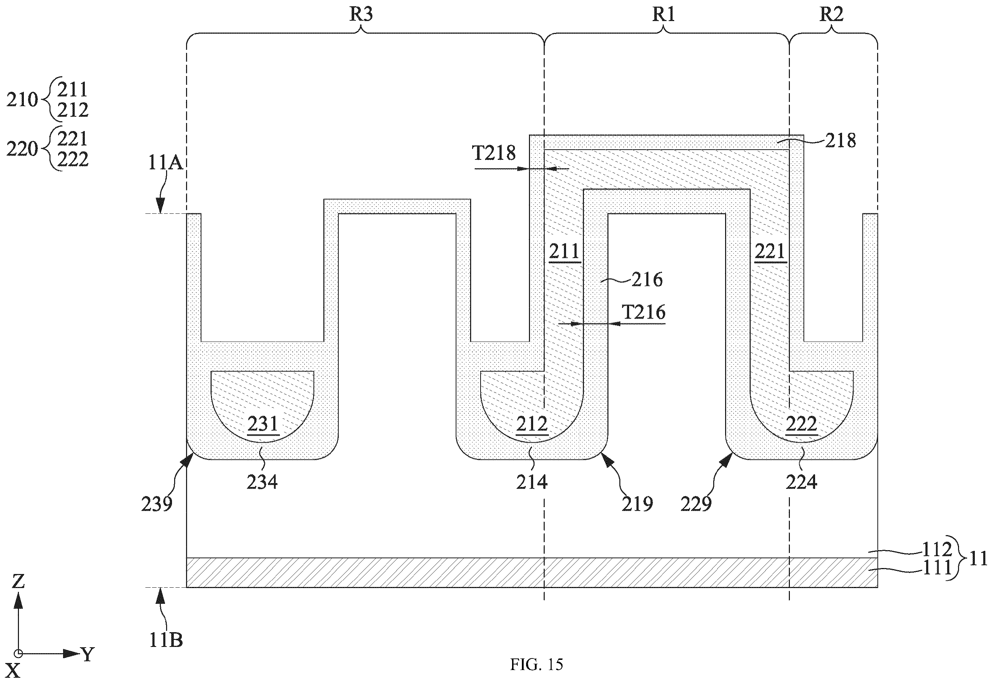

Referring to FIG. 15, the manufacturing method includes removing the second in-trench oxide layer 217. The manufacturing method includes removing the second in-trench oxide layer 217 located in the first region R1, the second region R2 and the third region R3, that is, removing the second in-trench oxide layer 217 that covers the first electrode 210, the second electrode 220 and the surface 11A, to expose part of the inner side surfaces (including the opposite sidewalls) of the epitaxial layer 112 of the first region R1, the first trench 219, the second trench 229 and the third trench 239, and the connected first electrode 210 and the second electrode 220 (not shown). The second in-trench oxide layer 217 is removed by etching. The epitaxial layer 112 exposed by removing the second in-trench oxide layer 217 has an even surface flatness. In some embodiments, the stage shown in FIG. 14 may be omitted.

The manufacturing method includes forming a third in-trench oxide layer 218 on the epitaxial layer 112 exposed in the third region R3, and on the top surfaces and sidewalls of the first electrode 210 and the second electrode 220 located in the first region R1 and the second region R2. The third in-trench oxide layer 218 is formed in the first region R1, the second region R2 and the third region R3, and at least part of the third in-trench oxide layer 218 is located in the first trench 219, the second trench 229 and the third trench 239. In some embodiments, the third in-trench oxide layer 218 covers the first surface 11A. In some embodiments, the third in-trench oxide layer 218 may be formed by the thermal oxidation technology or other deposition processes. In some embodiments, the third in-trench oxide layer 218 may be conformally deposited on the inner side surfaces (including the opposite sidewalls) of the first trench 219, the second trench 229 and the third trench 239 and the top surfaces and sidewalls of the first electrode 210 and the second electrode 220.

In some embodiments, the third in-trench inner oxide layer 218 may be filled into the first trench 219, the second trench 229, and the third trench 239 through a deposition process, such that the third in-trench inner oxide layer 218 covers and surrounds the first electrode 210 and the second electrode 220, and forms a groove with the first oxide layer 214 in the first trench 219, and forms a groove with the second oxide layer 224 in the second trench 229. In some embodiments, the thickness T218 of the third in-trench oxide layer 218 is less than the thickness T216 of the first in-trench oxide layer 216.

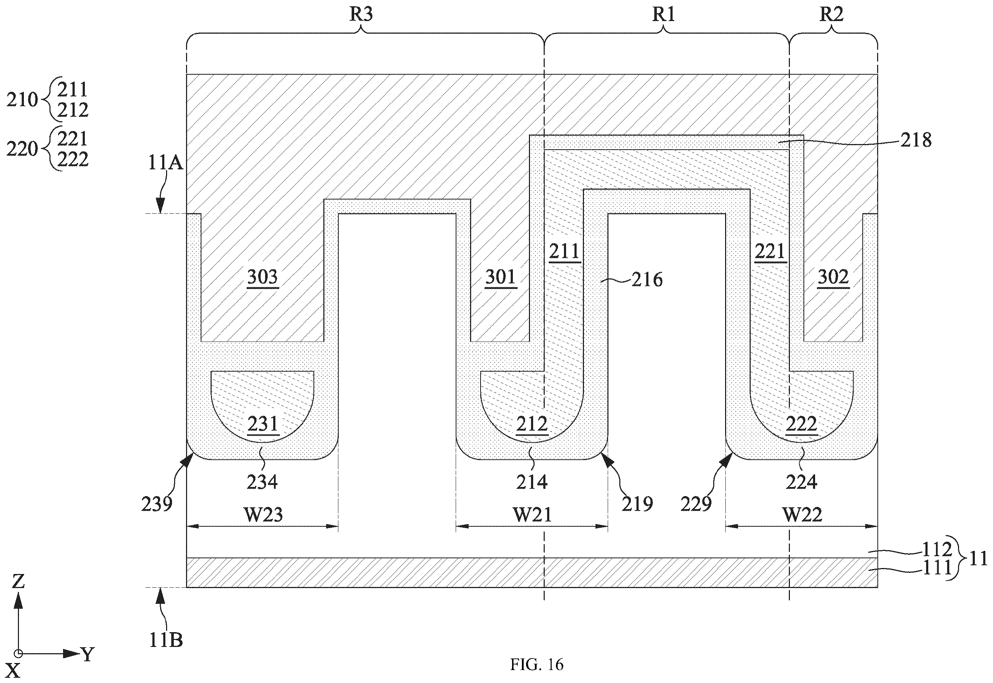

Referring to FIG. 16, the manufacturing method includes forming a first semiconductor material 301, a second semiconductor material 302, and a third semiconductor material 303 in the first trench 219, the second trench 229, and the third trench 239, respectively. In some embodiments, the first semiconductor material 301 is disposed in the first trench 219 and on the top surface of the first oxide layer 214, the second semiconductor material 302 is disposed in the second trench 229 and on the top surface of the second oxide layer 224, and the third semiconductor material 303 is disposed in the third trench 239 and on the top surface of the third oxide layer 234.

The third in-trench oxide layer 218 may surround the first semiconductor material 301, the second semiconductor material 302, and the third semiconductor material 303. In some embodiments, the first semiconductor material 301, the second semiconductor material 302, and the third semiconductor material 303 may be formed by physical vapor deposition (PVD), e.g., by sputtering or spraying semiconductor materials. In some embodiments, the first semiconductor material 301, the second semiconductor material 302, and the third semiconductor material 303 may be formed by electroplating or CVD of semiconductor materials. In some embodiments, the first semiconductor material 301, the second semiconductor material 302, and the third semiconductor material 303 include polysilicon. In some embodiments, the first semiconductor material 301, the second semiconductor material 302, and the third semiconductor material 303 cover the third in-trench oxide layer 218.

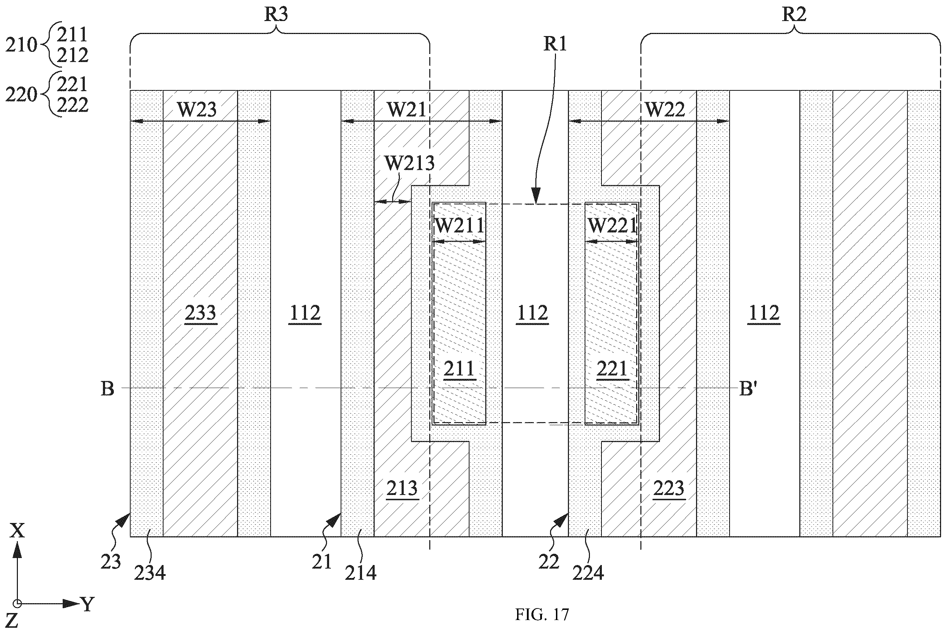

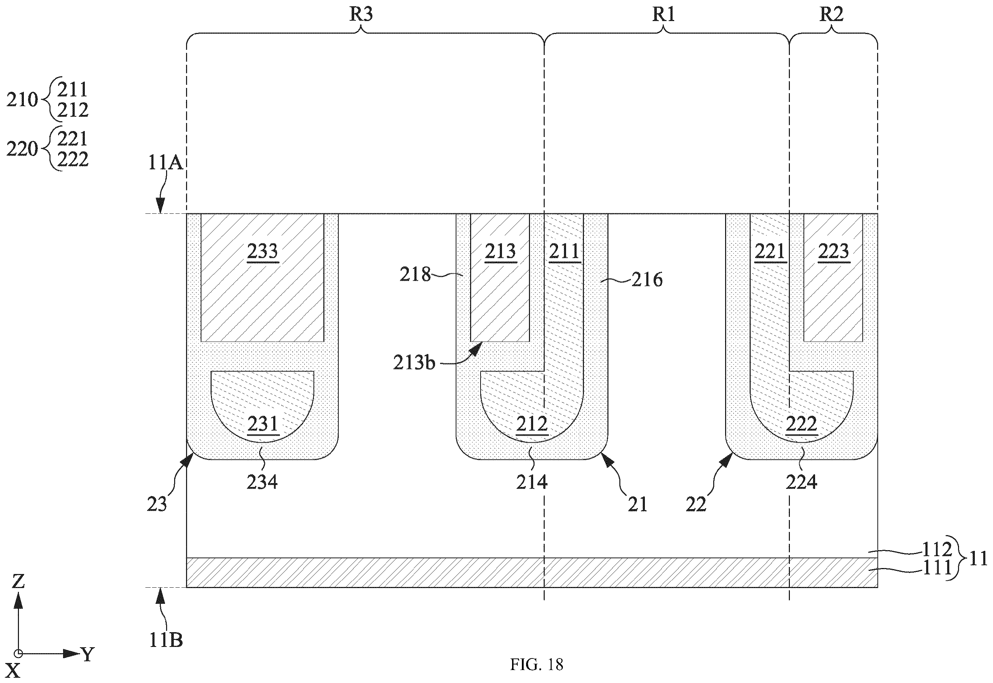

FIG. 17 is a top view of a stage in a manufacturing method of the semiconductor structure 10 according to some embodiments of the present application. FIG. 18 is a cross-sectional view taken along a line B-B ' at the stage shown in FIG. 17 in the manufacturing method of the semiconductor structure according to some embodiments of the present application.

Referring to FIG. 17 and FIG. 18, the manufacturing method includes removing a portion of the first semiconductor material 301 and a portion of the first electrode 210 above the first surface 11A of the semiconductor material layer 11, such that a portion of the first semiconductor material 301 located in the first trench 219 forms the first gate 213. A portion of the second semiconductor material 302 and a portion of the second electrode 220 above the first surface 11A of the semiconductor material layer 11 are removed, such that a portion of the second semiconductor material 302 located in the second trench 229 forms the second gate 223. A portion of the third semiconductor material 303 above the first surface 11A of the semiconductor material layer 11 is removed, such that a portion of the third semiconductor material 303 located in the third trench 239 forms the third gate 233, and the first surface 11A is exposed. Part of the first semiconductor material 301, part of the second semiconductor material 302, part of the third semiconductor material 303, part of the first in-trench oxide layer 216, part of the third in-trench oxide layer 218, part of the first electrode 210 and part of the second electrode 220 may be polished by, for example, a chemical - mechanical polishing (CMP) process.

In some embodiments, the first gate 213, the second gate 223, and the third gate 233 are formed simultaneously. The first electrode 210 is formed before forming the first gate 213. The second electrode 220 is formed before forming the second gate 223. In some embodiments, after forming the first gate 213 in the first trench 219, the first electrode 210 including the first portion 211 and the second portion 212, the first gate 213 adjacent to the first portion 211, and the first oxide layer 214 surrounding and separating the first electrode 210 and the first gate 213, form the first trench structure 21. After forming the second gate 223 in the second trench 229, the second electrode 220 including the third portion 221 and the fourth portion 222, the second gate 223 adjacent to the third portion 221, and the second oxide layer 224 surrounding and separating the second electrode 220 and the second gate 223, form the second trench structure 22. In some embodiments, after forming the third gate 233 in the third trench 239, the third gate 233 is located on the third electrode 231, and the third gate 233, the third electrode 231, and the third oxide layer 234 surrounding and separating the third gate 233 and the third electrode 231, form the third trench structure 23. In some embodiments, the first trench structure 21, the second trench structure 22, and the third trench structure 23 are formed simultaneously. In some embodiments, the top surface of the first trench structure 21, the top surface of the second trench structure 22, and the top surface of the third trench structure 23 are coplanar with the first surface 11A.

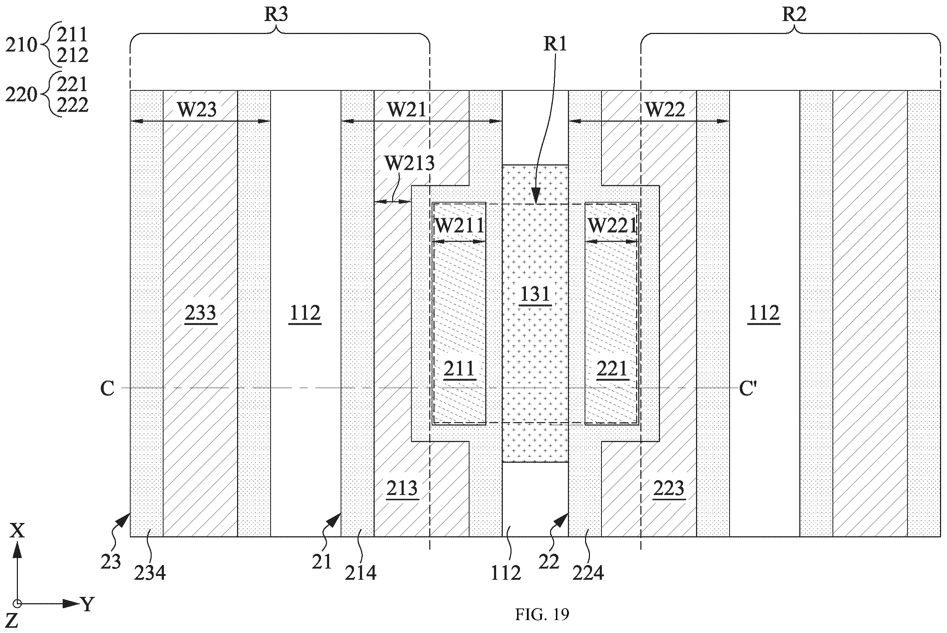

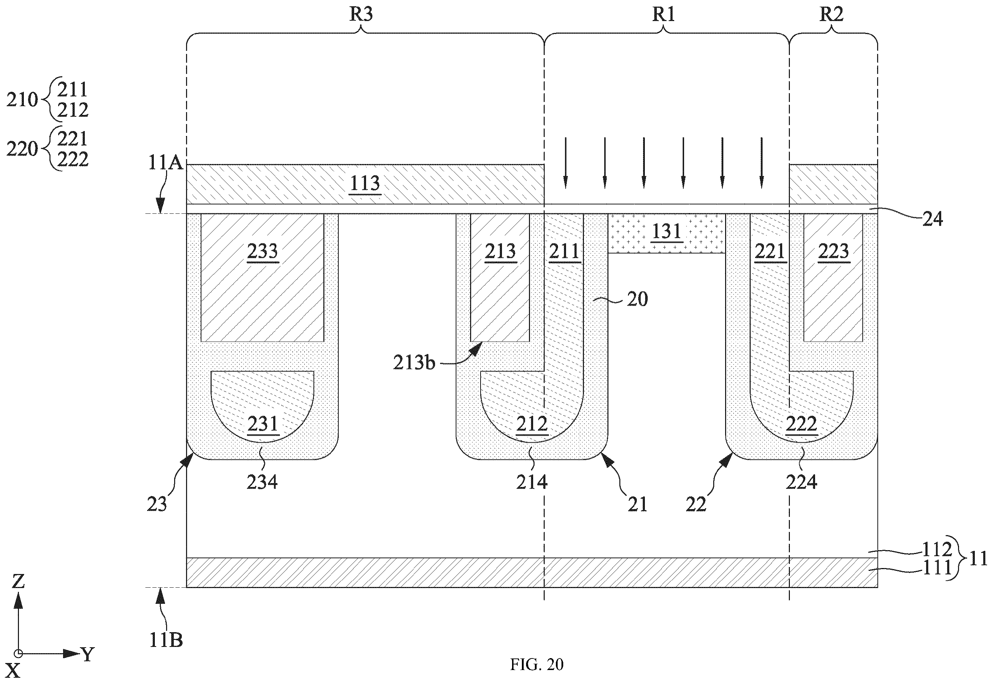

FIG. 19 is a top view of a stage in a manufacturing method of the semiconductor structure 10 according to some embodiments of the present application. FIG. 20 is a cross-sectional view taken along a line C-C ' at the stage shown in FIG. 19 in the manufacturing method of the semiconductor structure according to some embodiments of the present application.

Referring to FIG. 19 and FIG. 20, the manufacturing method includes forming a fourth oxide layer 24 on the top surface of the first trench structure 21, the top surface of the second trench structure 22, the top surface of the third trench structure 23 and the first surface 11A. The fourth oxide layer 24 is in contact with the first surface 11A of the semiconductor material layer 11, the first trench structure 21, the second trench structure 22, and the third trench structure 23. In some embodiments, the fourth oxide layer 24 may be formed by thermal oxidation technology or other deposition processes, such as ALD, CVD, or other deposition methods.

Referring to FIG. 20, the manufacturing method includes forming the first doped region 131 in the semiconductor material layer 11 between the first trench structure 21 and the second trench structure 22, and the first doped region 131 has a second conductivity type. The first doped region 131 may be formed in the epitaxial layer 112 by diffusion or ion implantation from the first surface 11A, and ions are implanted into the first surface 11A between the first trench structure 21 and the second trench structure 22 along the vertical direction Z. The first doped region 131 is formed in the first region R1, and the depth of the first doped region 131 is less than the depth of the first trench structure 21, the second trench structure 22, and the third trench structure 23. In other words, the bottom of the first doped region 131 is higher than the bottom of the first trench structure 21, the second trench structure 22, and the third trench structure 23. In some embodiments, an annealing process is performed after the first doped region 131 is formed by the ion implantation process to diffuse the doping ions. In some embodiments, the doping ions are, for example, boron ions, aluminum ions, gallium ions, indium ions, and so on. In some embodiments, boron ions are implanted into the first doped region 131.

In some embodiments, a first patterned shielding layer 113 is formed on the fourth oxide layer 24 to define the position of the first doped region 131, and the conductivity type and depth of the first doped region 131 are defined by adjusting the ions, energy and dose of the diffusion or ion implantation process. In some embodiments, the first patterned shielding layer 113 is formed by performing a photolithography process using a photomask having a corresponding pattern.

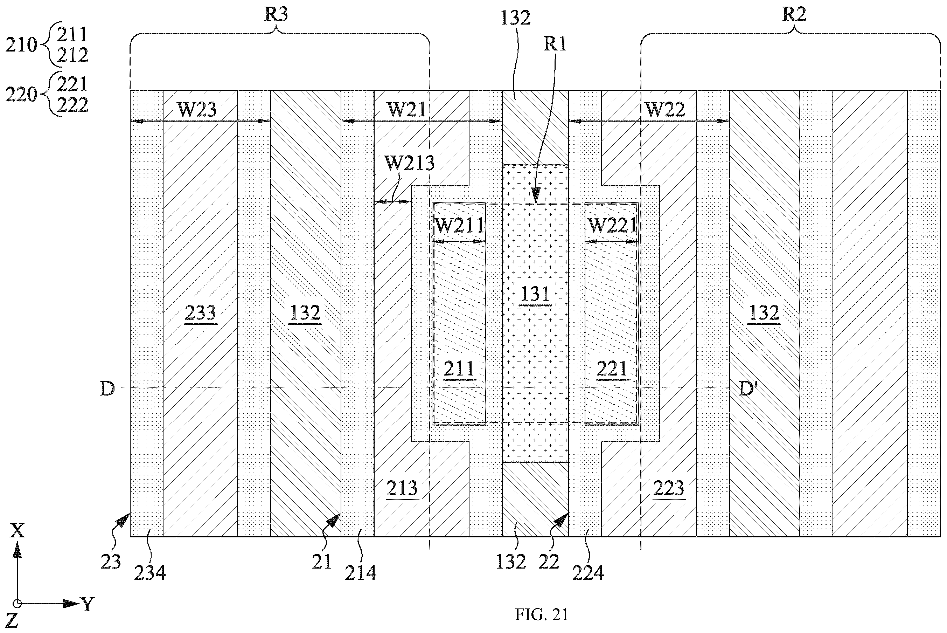

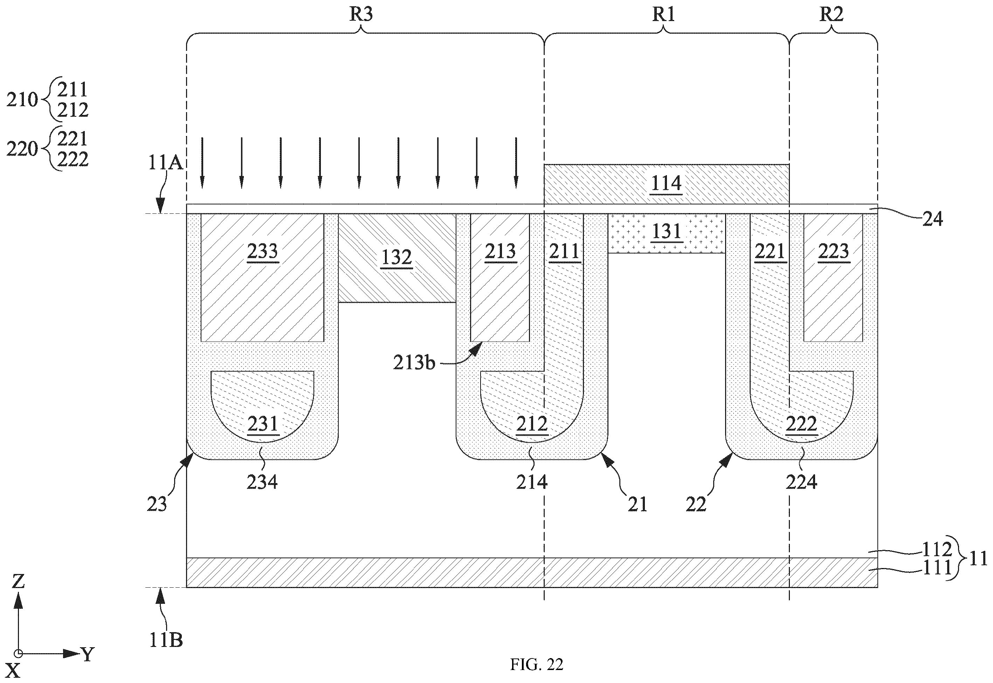

FIG. 21 is a top view of a stage in a manufacturing method of the semiconductor structure 10 according to some embodiments of the present application. FIG. 22 is a cross-sectional view taken along a line D-D ' at the stage shown in FIG. 21 in the manufacturing method of the semiconductor structure according to some embodiments of the present application.

Referring to FIG. 21 and FIG. 22, the manufacturing method includes forming the second doped region 132 in the semiconductor material layer 11 between the second trench structure 22 and the third trench structure 23, and the second doped region 132 has a second conductivity type. The second doped region 132 may be formed in the epitaxial layer 112 by diffusion or ion implantation from the first surface 11A, and the ions are implanted into the first surface 11A along the vertical direction Z. The second doped region 132 is formed in the second region R2 or the third region R3, and the depth of the second doped region 132 is less than the depth of the first trench structure 21, the second trench structure 22 and the third trench structure 23. In other words, the bottom of the second doped region 132 is higher than the bottom of the first trench structure 21, the second trench structure 22 and the third trench structure 23. In some embodiments, an annealing process is performed after the second doped region 132 is formed by the ion implantation process to diffuse the doping ions. In some embodiments, the doping ions are, for example, boron ions, aluminum ions, gallium ions, indium ions, and so on. In some embodiments, boron ions are implanted into the second doped region 132. The bottom of the second doped region 132 is lower than that of the first doped region 131.

In some embodiments, a second patterned shielding layer 114 is formed on the fourth oxide layer 24 to define the position of the second doped region 132, and the conductivity type and depth of the second doped region 132 are defined by adjusting the ions, energy and dose of the diffusion or ion implantation process. In some embodiments, the second patterned shielding layer 114 is formed by a photolithography process using a photomask having a corresponding pattern. The first doped region 131 and the second doped region 132 are formed separately and have the same or different doping concentrations. In some embodiments, the first doped region 131 is formed before the second doped region 132 is formed. In some embodiments, the doping concentration of the second doped region 132 is greater than the doping concentration of the first doped region 131.

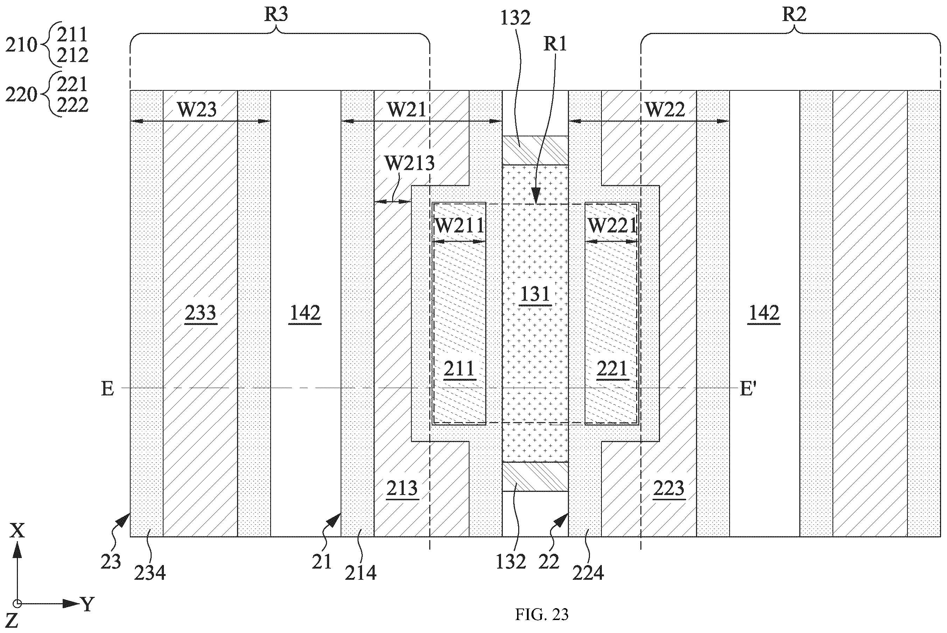

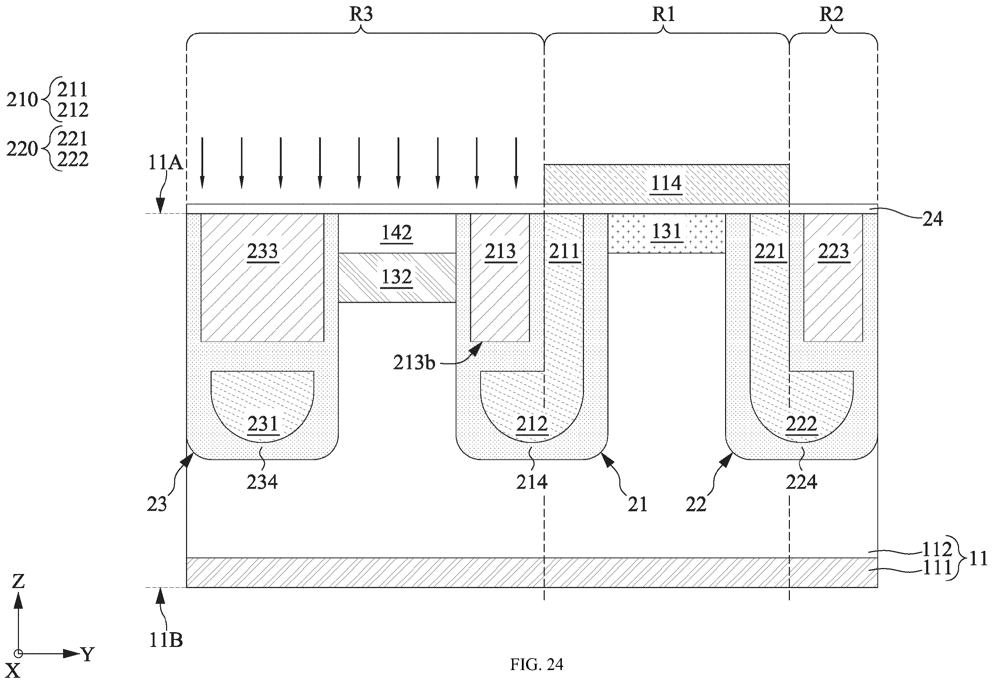

FIG. 23 is a top view of a stage in a manufacturing method of the semiconductor structure 10 according to some embodiments of the present application. FIG. 24 is a cross-sectional view taken along a line E-E ' at the stage shown in FIG. 23 in the manufacturing method of the semiconductor structure according to some embodiments of the present application.

Referring to FIG. 23 and FIG. 24, the manufacturing method includes forming the third doped region 142 in the second doped region 132 adjacent to the first surface 11A of the semiconductor material layer 11, where the third doped region 142 is a heavily doped region of the first conductivity type. The third doped region 142 is formed between the second doped region 132 and the fourth oxide layer 24.

The third doped region 142 may be formed in the epitaxial layer 112 by diffusion or ion implantation from the first surface 11A, and ions are implanted into the first surface 11A along the vertical direction Z. The third doped region 142 is formed in the second region R2 or the third region R3, and the depth of the third doped region 142 is less than the depth of the second doped region 132. In other words, the bottom of the third doped region 142 is higher than the bottom of the second doped region 132. In some embodiments, an annealing process is performed after the third doped region 142 is formed by the ion implantation process to diffuse the doped ions. In some embodiments, the first doped region 131 is formed before the third doped region 142 is formed.

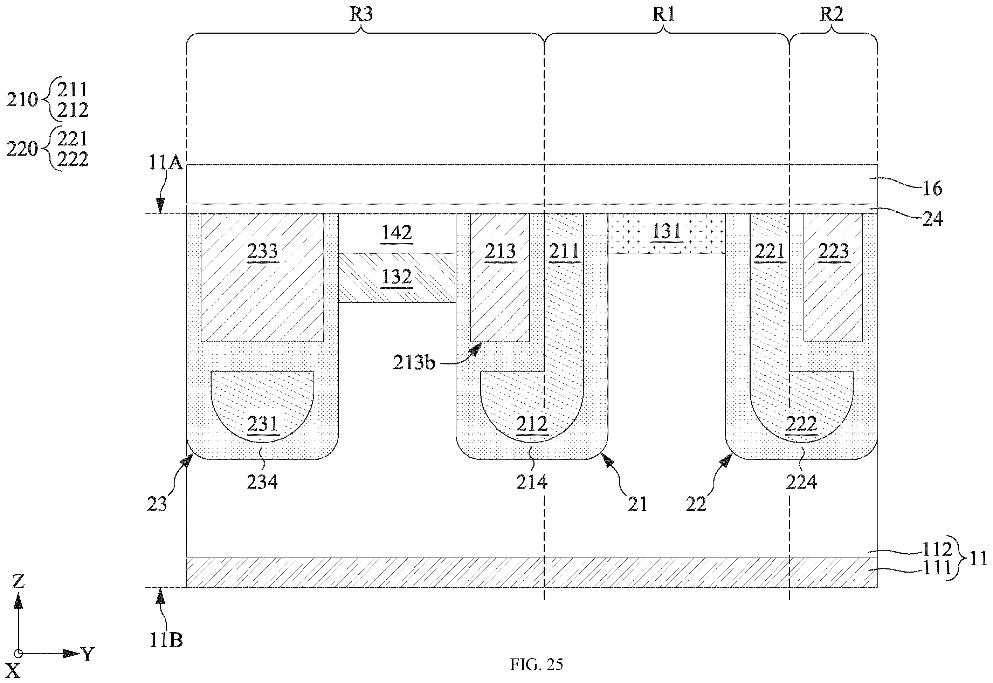

Referring to FIG. 25, the manufacturing method includes forming the interlayer dielectric layer 16 on the first surface 11A of the semiconductor material layer 11, and the interlayer dielectric layer 16 covers the first trench structure 21, the second trench structure 22, the third trench structure 23, the first doped region 131, and the third doped region 142. The manufacturing method includes forming the interlayer dielectric layer 16 on the fourth oxide layer 24. The interlayer dielectric layer 16 may be formed by the thermal oxidation technology or other deposition processes.

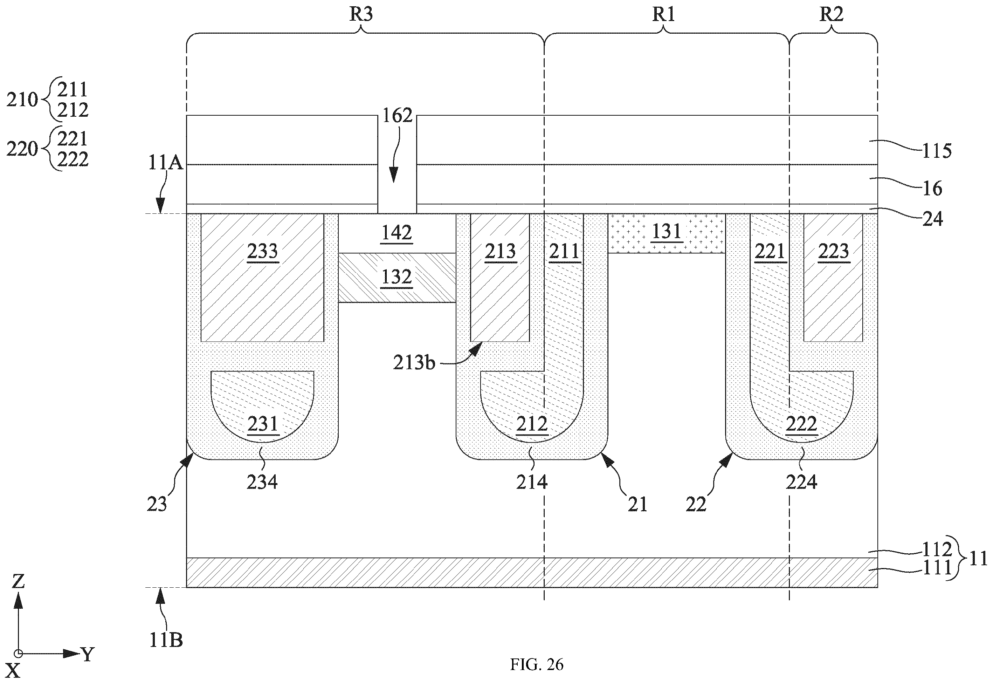

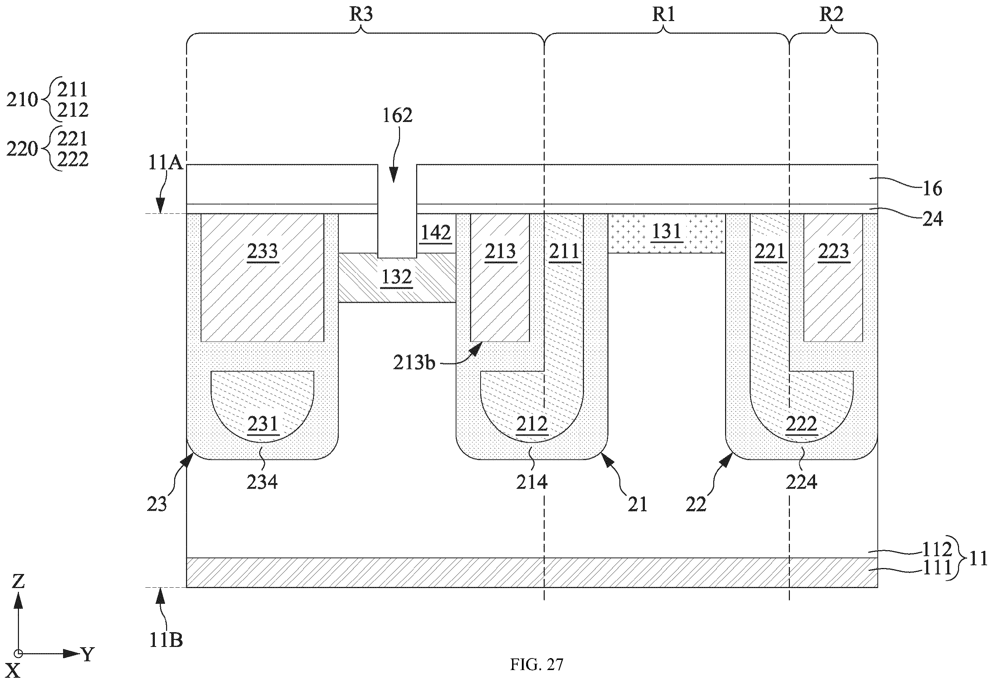

Referring to FIG. 26 and FIG. 27, the manufacturing method includes partially removing the interlayer dielectric layer 16 and the fourth oxide layer 24, and partially removing the epitaxial layer 112 to form the second opening 162. The second opening 162 may be formed by one or more etching processes. The second opening 162 is located between the first trench structure 21 and the third trench structure 23, penetrates through the third doped region 142 and stops in the second doped region 132.

In some embodiments, referring to FIG. 26, a third patterned shielding layer 115 is formed on the interlayer dielectric layer 16 to define the position of the second opening 162, and the interlayer dielectric layer 16 and the fourth oxide layer 24 in the third region R3 are partially removed by adjusting the position of the third patterned shielding layer 115. In some embodiments, the third patterned shielding layer 115 is formed by performing a photolithography process using a photomask having a corresponding pattern. Referring to FIG. 27, after partially removing the interlayer dielectric layer 16 and the fourth oxide layer 24, the third patterned shielding layer 115 is removed, and the interlayer dielectric layer 16 and the fourth oxide layer 24 are used as masks to further partially remove the epitaxial layer 112 to form the second opening 162.

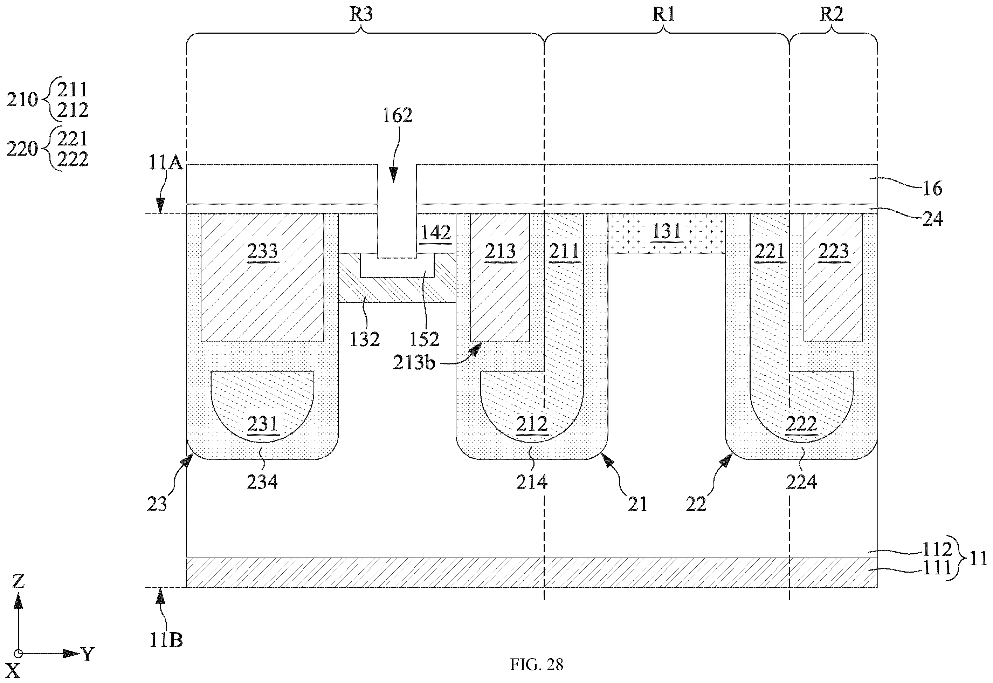

Referring to FIG. 28, the manufacturing method includes performing an ion implantation process on the epitaxial layer 112 through the second opening 162 to form the heavily doped region 152 in the third region R3. Ions are implanted into the epitaxial layer 112 at the bottom of the second opening 162 along the vertical direction Z. The heavily doped region 152 is formed in the epitaxial layer 112 adjacent to the bottom of the second opening 162. In some embodiments, an annealing process is performed after the ion implantation process to form the heavily doped region 152 as shown in FIG. 28.

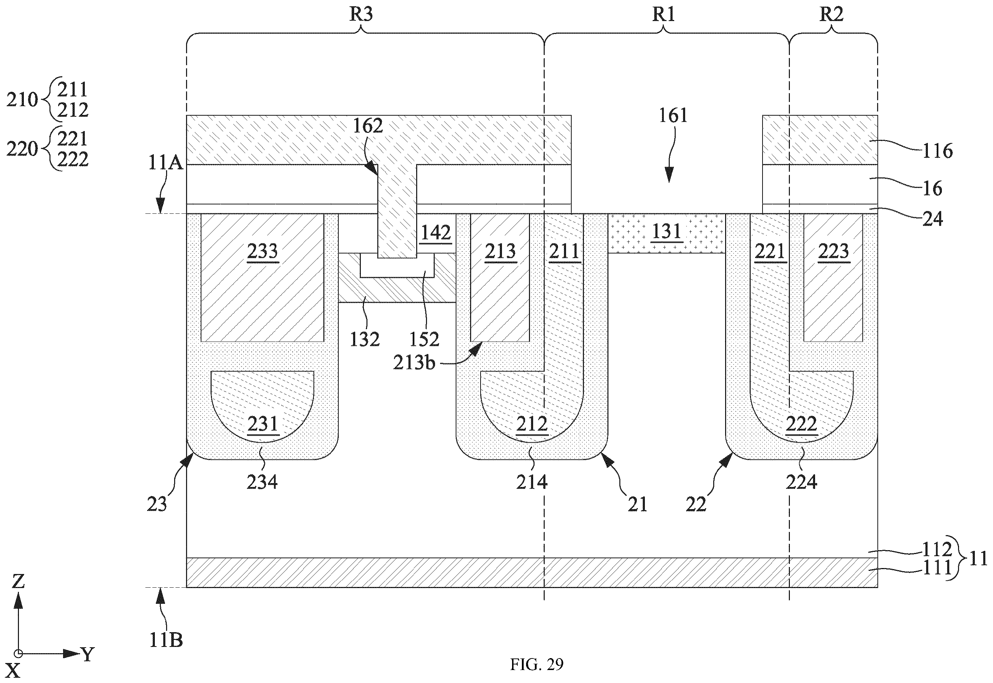

Referring to FIG. 29, the manufacturing method includes partially removing the interlayer dielectric layer 16 and the fourth oxide layer 24 in the first region R1 to form the first opening 161. The first opening 161 may be formed by one or more etching processes. The first opening 161 is located on the electrode structure in the first region R1 between the first trench structure 21 and the second trench structure 22 and stops at the first surface 11A, exposing the first portion 211 of the first electrode 210 and the third portion 221 of the second electrode 220, respectively. The width of the first opening 161 is greater than the width of the second opening 162.

In some embodiments, a fourth patterned shielding layer 116 is formed on the interlayer dielectric layer 16 to define the position of the first opening 161, and the interlayer dielectric layer 16 and the fourth oxide layer 24 in the first region R1 are partially removed by adjusting the position of the fourth patterned shielding layer 116. In some embodiments, the fourth patterned shielding layer 116 is formed by performing a photolithography process using a photomask having a corresponding pattern.

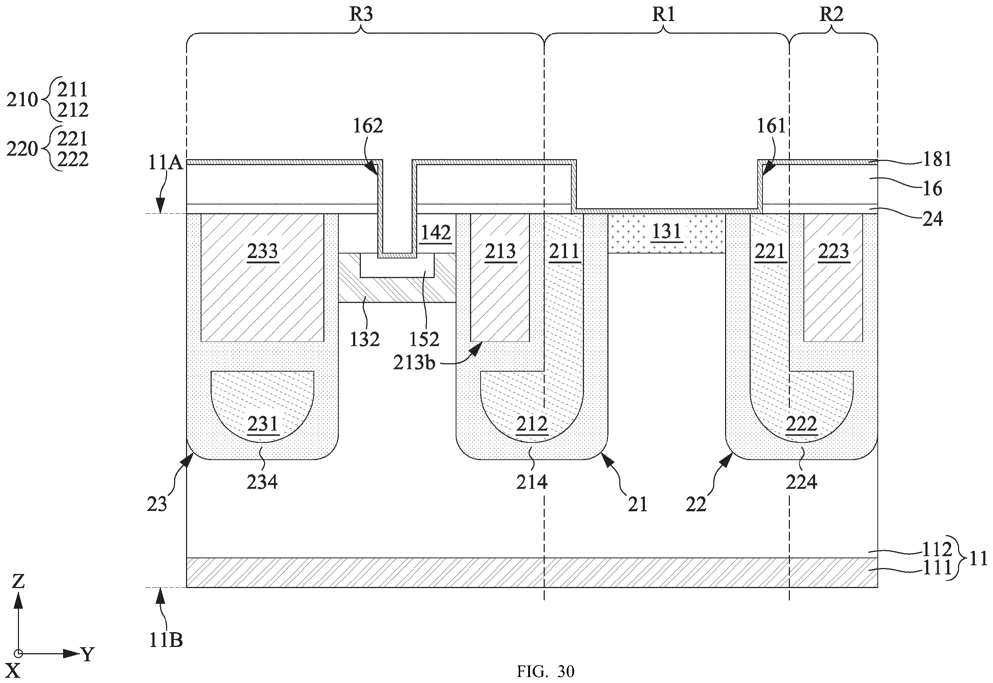

Referring to FIG. 30, the manufacturing method includes forming the shielding metal layer 181 on the interlayer dielectric layer 16 and in the first groove 161 and the second groove 162.

In some embodiments, the shielding metal layer 181 covers the interlayer dielectric layer 16. In some embodiments, the first in-trench oxide layer 181 may be formed by thermal oxidation technology or other deposition processes, and the deposition processes may be, for example, ALD, CVD or other deposition methods. In some embodiments, the shielding metal layer 181 may be conformally deposited on the inner side surfaces of the first groove 161 and the second groove 162 (including the opposite sidewalls and the bottom extending between the sidewalls). In some embodiments, the shielding metal layer 181 may be filled into the first groove 161 and the second groove 162 through a deposition process, such that the shielding metal layer 181 forms at least one groove in the first groove 161 and the second groove 162, respectively.

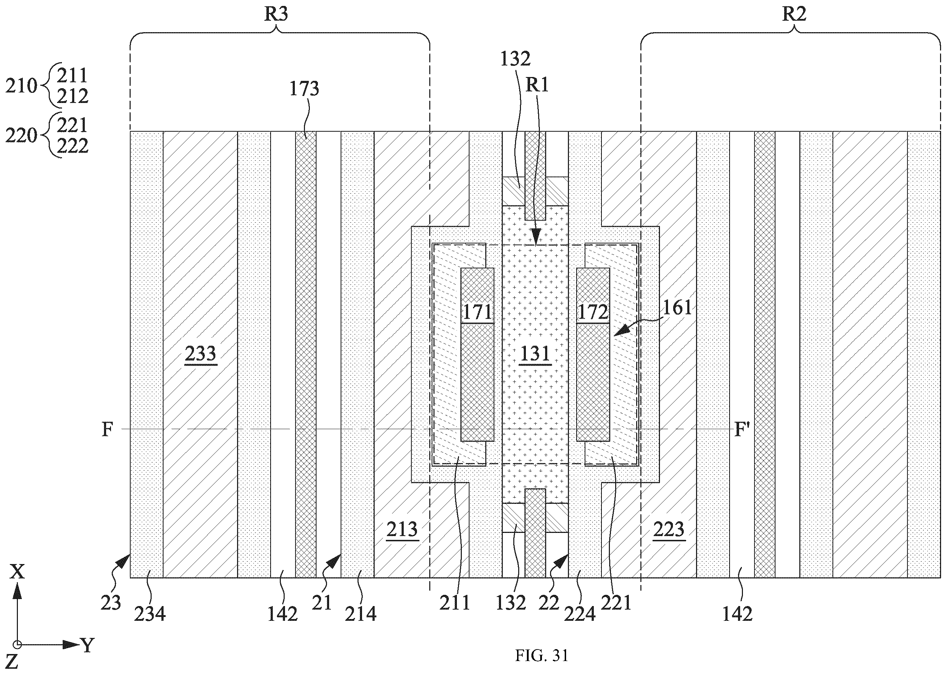

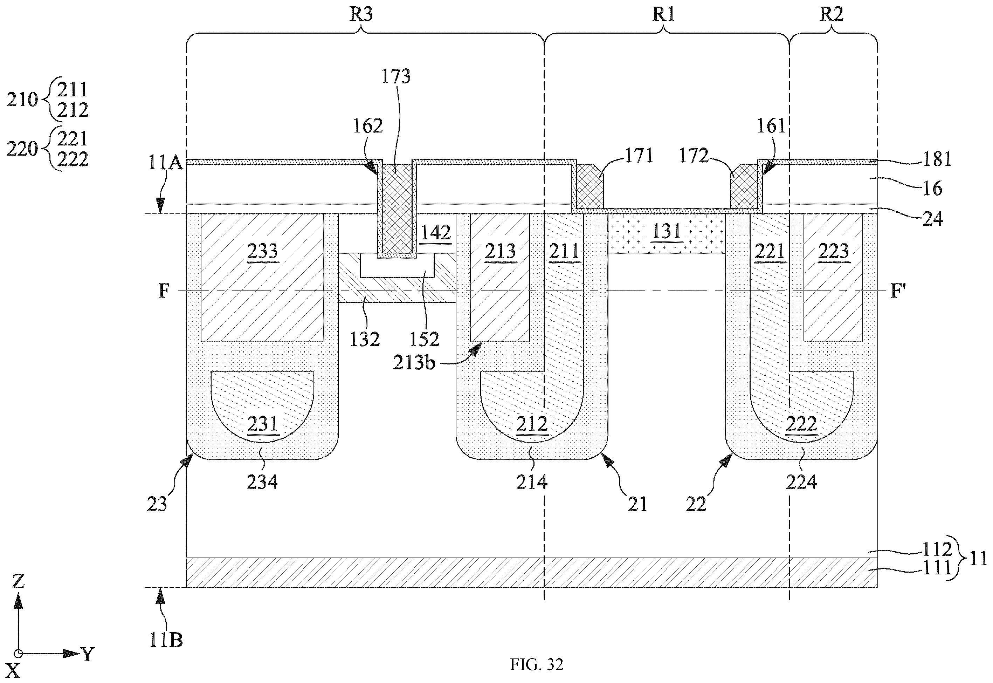

FIG. 31 is a top view of a stage in a manufacturing method of the semiconductor structure 10 according to some embodiments of the present application. FIG. 32 is a cross-sectional view taken along a line F-F' at the stage shown in FIG. 31 in the manufacturing method of the semiconductor structure according to some embodiments of the present application.

Referring to FIG. 31 and FIG. 32, the manufacturing method includes forming the first conductive plug 171, the second conductive plug 172 in the first opening 161, and the third conductive plug 173 in the second opening 162. The first conductive plug 171 and the second conductive plug 172 are formed on two sides of the first opening 161 and are separated from each other. The first conductive plug 171 is disposed on the first electrode 210 and the first oxide layer 214, and the second conductive plug 172 is disposed on the second electrode 220 and the second oxide layer 224.

The first conductive plug 171, the second conductive plug 172, and the third conductive plug 173 may be formed by filling a conductive material into the first opening 161 and the second opening 162, respectively, through e.g., electroplating or CVD. The first conductive plug 171, the second conductive plug 172, and the third conductive plug 173 are formed on the shielding metal layer 181, and can be formed simultaneously or separately. The material may include gold (Au), silver (Ag), copper (Cu), platinum (Pt), palladium (Pd), tungsten (W), titanium (Ti), tantalum (Ta), molybdenum (Mo) or other metals or alloys. In some embodiments, a planarization process may be selectively performed after electroplating or CVD. In some embodiments, the top surfaces of the first conductive plug 171, the second conductive plug 172 and the third conductive plug 173 are flush or located at approximately the same level. In some embodiments, the top surfaces of the first conductive plug 171, the second conductive plug 172 and the third conductive plug 173 are slightly lower than the height of the shielding metal layer 181.

From the top view of FIG. 31, the configurations of the first conductive plug 171 and the second conductive plug 172 are defined by the first opening 161. The first conductive plug 171 overlaps with the first electrode 210 in the first region R1, and the second conductive plug 172 overlaps with the second electrode 220 in the first region R1. The configuration of the third conductive plug 173 is defined by the configuration of the second opening 162, and thus has the same configuration as the second opening 162. The third conductive plug 173 is surrounded by the third doped region 142 and the heavily doped region 152 in the third region R3.

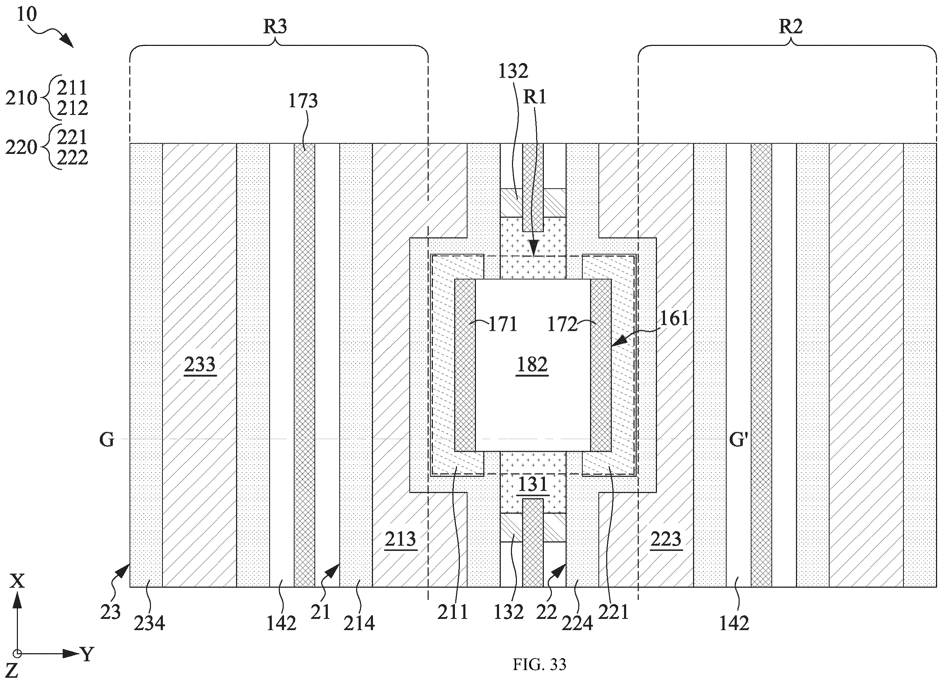

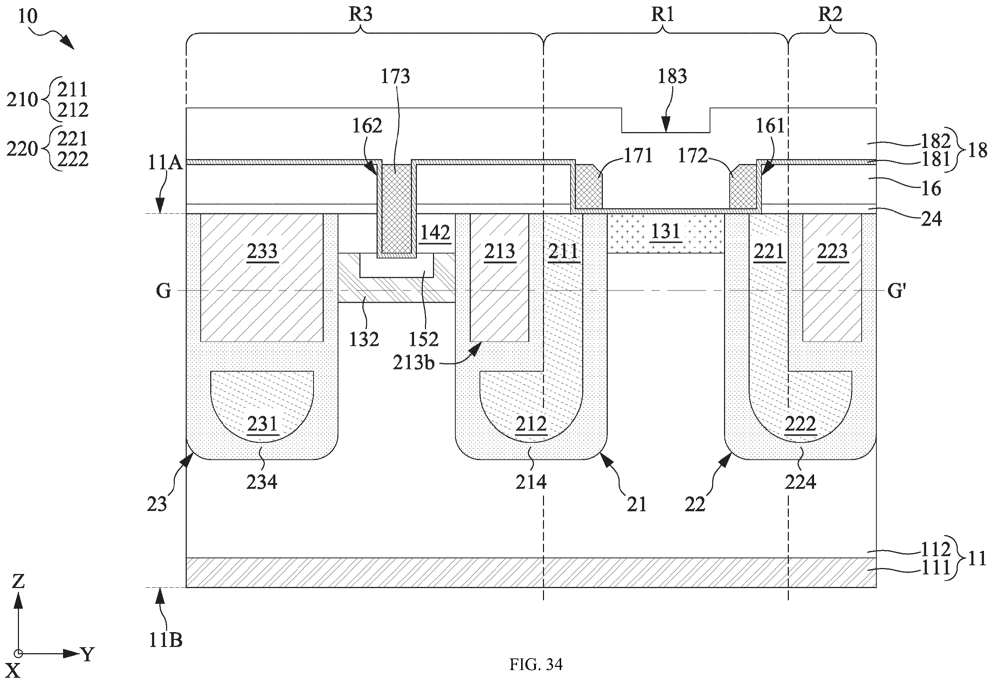

FIG. 33 is a top view of a stage in a manufacturing method of the semiconductor structure 10 according to some embodiments of the present application. FIG. 34 is a cross-sectional view taken along a line G-G' at the stage shown in FIG. 33 in the manufacturing method of the semiconductor structure according to some embodiments of the present application.

Referring to FIG. 33 and 34, the manufacturing method includes forming the metal layer 182 on the interlayer dielectric layer 16 to form the trench semiconductor structure 10. The shielding metal layer 181 and the metal layer 182 constitute a conductive material layer. The metal layer 182 may be formed by electroplating or CVD, and the metal layer 182 may be patterned according to electrical properties and operational requirements. The material of the metal layer 182 may include copper (Cu), gold (Au), silver (Ag), aluminum (Al), nickel (Ni), titanium (Ti), tungsten (W), tin (Sn) or other metals or alloys. In some embodiments, the metal layer 182 is defined as a plurality of metal lines by an etching process. In some embodiments, the metal layer 182 contacts and is electrically connected to the shielding metal layer 181, the first conductive plug 171, the second conductive plug 172, and the third conductive plug 173. The first conductive plug 171, the second conductive plug 172, and the third conductive plug 173 extend from the metal layer 182 in the vertical direction Z. The first conductive plug 171 is formed between the first trench structure 21 and the metal layer 182, the second conductive plug 172 is formed between the second trench structure 22 and the metal layer 182, and the third conductive plug 173 is formed between the second doped region 132 and the metal layer 182.

The trench semiconductor structure 10 formed by the above steps can be basically the same as the semiconductor structure 10 shown in FIGs. 1 to 3. The trench semiconductor structure 10 has the first trench structure 21 including the first electrode 210 and the first gate 213, the second trench structure 22 including the second electrode 220 and the second gate 223. The first electrode 210 includes the first portion 211 adjacent to the first gate 213, and the second portion 212 located below the first portion 211 and the first gate 213 and connected to the first portion 211. The first doped region 131 is disposed between the first electrode 210 and the second electrode 220. The first electrode 210, the second electrode 220, the first doped region 131 and the above conductive material layer 18 form a TMBS. The trench semiconductor structure 10 integrates at least part of the TMBS and at least part of the SGT MOSFET in the same trench, improves the chip area utilization and achieves the effect of effectively using space.

According to the structures and processes of the present disclosure described above, and under the same purpose and concept, the steps in the above processes can be adjusted or orders of the steps may be changed to achieve the same or similar semiconductor structure.

In this disclosure, for description convenience, spatially relative terms such as "below", "under", "lower", "above", "upper", "left side", "right side", and the like, may be used to describe the relationship of one component or feature with another one or more components or features, as shown in the accompanying drawings. The spatially relative terms are not only used to depict the orientations in the accompanying drawings, but also intended to encompass different orientations of a device in use or operation. A device may be oriented in other ways (rotated 90 degrees or in other orientations), and the spatially relative terms used herein may be interpreted in a corresponding way similarly. It should be understood that when a component is referred to as being "connected to" or "coupled to" another component, it may be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of the endpoints unless otherwise indicated. The term "substantially coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "substantially" the same, the term may refer to a value that is within ±10%, ±5%, ±1%, or ±0.5% of the mean of the values. The foregoing summarizes the features of several embodiments and detailed aspects of the present disclosure. The embodiments described in the present disclosure can be easily used as a basis for designing or modifying other processes and structures to facilitate the implementation of the same or similar purposes and/or to achieve the same or similar advantages of the embodiments presented herein. Such equivalent constructions do not depart from the spirit and scope of the present disclosure, and various changes, substitutions and modifications may be made without departing from the spirit and scope of the present disclosure.

## Claims

1. A trench semiconductor structure, comprising:
a semiconductor material layer having a first surface and a second surface opposite to the first surface, wherein the semiconductor material layer is of a first conductivity type;
a first trench structure extending from the first surface towards the second surface, wherein the first trench structure includes a first electrode, a first gate, and a first oxide layer separating the first electrode from the first gate, the first electrode includes a first portion adjacent to the first gate and a second portion located below the first portion and the first gate and connected to the first portion;
a first doped region, located in the semiconductor material layer adjacent to the first surface and adjacent to the first portion of the first electrode, wherein the first doped region is of a second conductivity type;
an interlayer dielectric layer, disposed on the first surface of the semiconductor material layer and covering the first trench structure;
a shielding metal layer, covering the interlayer dielectric layer and the first doped region, and contacting the first electrode; and
a metal layer, on the interlayer dielectric layer and the first doped region,
wherein the first portion of the first electrode is located between the first doped region and the first gate, and the first electrode and the first doped region are both in contact with the shielding metal layer to be electrically connected to the metal layer.

2. The trench semiconductor structure according to claim 1, wherein the first electrode and the first doped region form a trench MOS barrier Schottky (TMBS) diode.

3. The trench semiconductor structure according to claim 1, wherein the first portion and the second portion of the first electrode are formed integrally.

4. The trench semiconductor structure according to claim 1, wherein a width of the second portion of the first electrode is greater than a width of the first portion of the first electrode.

5. The trench semiconductor structure according to claim 1, further comprising:
a groove located on the first doped region and the shielding metal layer and extending through the interlayer dielectric layer, wherein at least a portion of the metal layer and at least a portion of the shielding metal layer are located in the groove; and
a first conductive plug located in the groove and electrically connected to the first electrode and the metal layer.

6. The trench semiconductor structure according to claim 1, further comprising:
a second trench structure extending from the first surface towards the second surface and disposed adjacent to the first trench structure, wherein the second trench structure comprises a second electrode, a second gate, and a second oxide layer separating the second electrode from the second gate, the second electrode comprises a third portion adjacent to the second gate, and a fourth portion located below the third portion and the second gate and connected to the third portion,
wherein the third portion of the second electrode is located between the second gate and the first doped region, and the second electrode is in contact with the shielding metal layer to be electrically connected to the metal layer.

7. The trench semiconductor structure according to claim 6, wherein a trench depth of the first trench structure is the same as a trench depth of the second trench structure.

8. The trench semiconductor structure according to claim 6, wherein a trench width of the first trench structure is the same as or different from a trench width of the second trench structure.

9. The trench semiconductor structure according to claim 6, wherein the first electrode, the second electrode and the first doped region form a trench MOS barrier Schottky (TMBS) diode.

10. The trench semiconductor structure according to claim 6, further comprising:
a groove located on the first doped region and the shielding metal layer and extending through the interlayer dielectric layer; and
a second conductive plug located in the groove and electrically connected to the second electrode and the metal layer,
wherein at least part of the metal layer and at least part of the shielding metal layer are located in the groove and are electrically connected to the second conductive plug.

11. The trench semiconductor structure of claim 1, wherein a width of the first gate is greater than a width of the first portion of the first electrode.

12. The trench semiconductor structure according to claim 1, further comprising:
a third trench structure extending from the first surface towards the second surface and disposed adjacent to the first trench structure, wherein the third trench structure comprises a third electrode, a third gate located on the third electrode, and a third oxide layer separating the third electrode and the third gate from each other;
a second doped region, located in the semiconductor material layer, adjacent to the first surface and between the first trench structure and the third trench structure, wherein the second doped region is of the second conductivity type;
a third doped region, located between the first surface and the second doped region, wherein the third doped region is of the first conductivity type; and
a third conductive plug electrically connected to the second doped region and the metal layer,
wherein the interlayer dielectric layer covers the third trench structure and the third doped region.

13. The trench semiconductor structure according to claim 12, wherein a doping concentration of the second doped region is greater than a doping concentration of the first doped region.

14. The trench semiconductor structure according to claim 12, wherein the first gate, the third electrode, the third gate, the second doped region, the third doped region and the third conductive plug form a shielded gate trench metal oxide semiconductor field effect transistor (SGT MOSFT).

15. The trench semiconductor structure according to claim 12, wherein at least a portion of the third conductive plug is surrounded by the third doped region and electrically connected to the metal layer.

16. The trench semiconductor structure according to claim 15, wherein the third conductive plug extends through the third doped region.

17. The trench semiconductor structure of claim 1, wherein the first oxide layer located between the first portion of the first electrode and the semiconductor material layer has a first thickness, the first oxide layer located between the first gate and the semiconductor material layer has a second thickness, and the second thickness is less than the first thickness.

18. The trench semiconductor structure according to claim 1, further comprising:
a fourth oxide layer located on the first surface of the semiconductor material layer and between the interlayer dielectric layer and the first trench structure.

19. A trench semiconductor structure, comprising:
a semiconductor material layer having a first conductivity type, and having a first region and a second region surrounding the first region;
a first trench structure, recessed into the semiconductor material layer, and comprising a first electrode, a first gate, and a first oxide layer surrounding the first electrode and the first gate, wherein the first electrode includes a first portion adjacent to the first gate, and a second portion overlapping with the first portion and the first gate and connected to the first portion when viewed from a top view;
a second trench structure, recessed into the semiconductor material layer, and comprising a second electrode, a second gate, and a second oxide layer surrounding the second electrode and the second gate; and
a first doped region disposed in the semiconductor material layer and between the first trench structure and the second trench structure, wherein the first doped region has a second conductivity type,
wherein the first electrode and the second electrode are disposed between the first gate and the second gate,
a portion of the first electrode, a portion of the second electrode, and the first doped region between the first electrode and the second electrode are located in the first region, and
the first gate and the second gate are located in the second region.

20. The trench semiconductor structure according to claim 19, wherein the first region comprises a trench MOS barrier Schottky (TMBS) diode, and the second region comprises a shielded gate trench metal oxide semiconductor field effect transistor (SGT MOSFT).

21. The trench semiconductor structure according to claim 19, further comprising:
a third trench structure, recessed into the semiconductor material layer, and comprising a third electrode, a third gate, and a third oxide layer surrounding the third electrode and the third gate and separating the third electrode and the third gate from each other,
wherein the first electrode, the second electrode and the first gate extend along a first direction, and the third gate has a mesh structure, includes a fifth portion extending along the first direction and a sixth portion extending along a second direction different from the first direction.

22. The trench semiconductor structure according to claim 19, wherein a length of the first portion of the first electrode is the same as or different from a length of the third portion of the second electrode when viewed from a top view.

23. A method of manufacturing for a trench semiconductor structure, comprising:
forming a first trench in a semiconductor material layer, wherein the first trench extends from a first surface towards a second surface;
forming a first electrode in the first trench, wherein the first electrode comprises a first portion and a second portion located below the first portion and connected to the first portion;
forming a first gate in the first trench, wherein the first gate is adjacent to the first portion of the first electrode and is located above the second portion of the first electrode, and the first electrode and the first gate form a first trench structure;
forming a first doped region in the semiconductor material layer adjacent to the first surface, wherein the first doped region has a second conductivity type, and the first portion of the first electrode is located between the first doped region and the first gate;
forming an interlayer dielectric layer on the first surface of the semiconductor material layer, wherein the interlayer dielectric layer covers the first trench structure and the first doped region;
forming a groove extending through the interlayer dielectric layer to expose the first doped region and the first portion of the first electrode;
forming a shielding metal layer in the groove and on the interlayer dielectric layer, wherein the shielding metal layer covers the interlayer dielectric layer and the first doped region and contacts the first portion of the first electrode; and
forming a metal layer in the groove and on the interlayer dielectric layer and the shielding metal layer,
wherein the first portion of the first electrode and the first doped region are in contact with the shielding metal layer to be electrically connected to the metal layer.

24. The method according to claim 23, wherein the first portion and the second portion of the first electrode are formed simultaneously.

25. The method according to claim 23, further comprising:
forming a first conductive plug between the first trench structure and the metal layer, wherein the first conductive plug is located in the groove and surrounded by the metal layer and the shielding metal layer, and is located on the first portion of the first electrode; and
forming a second conductive plug in the groove, and separated from the first conductive plug and the first trench structure,
wherein at least a portion of the metal layer is located between the first conductive plug and the second conductive plug.

26. The method according to claim 25, wherein the first conductive plug and the second conductive plug are formed simultaneously.

27. The method according to claim 23, further comprising:
forming a second trench in the semiconductor material layer, wherein the second trench extends from the first surface towards the second surface and is disposed adjacent to the first trench;
forming a second electrode in the second trench, wherein the second electrode comprises a third portion and a fourth portion located below the third portion and connected to the third portion; and
forming a second gate in the second trench, wherein the second gate is adjacent to the third portion of the second electrode and is located above the fourth portion of the second electrode, and the third portion, the fourth portion and the second gate of the second electrode form a second trench structure,
wherein the first doped region is between the first trench structure and the second trench structure, the interlayer dielectric layer covers the second trench structure, and the groove exposes the third portion.

28. The method according to claim 27, wherein the first electrode and the second electrode are formed simultaneously.

29. The method according to claim 27, wherein forming the first trench structure in the first trench and forming the second trench structure in the second trench further comprise:
forming a first oxide layer in the first trench, wherein the first electrode and the first gate are surrounded by the first oxide layer; and
forming a second oxide layer in the second trench, wherein the second electrode and the second gate are surrounded by the second oxide layer.

30. The method according to claim 23, further comprising:
forming a third trench in the semiconductor material, wherein the third trench extends from the first surface towards the second surface, and the first trench is located between the third trench and the second trench; and
forming a third electrode, a third gate located on the third electrode, and a third oxide layer surrounding the third electrode and the third gate and separating the third electrode and the third gate from each other,
wherein the third electrode, the third gate and the third oxide layer form a third trench structure, and the first trench structure is located between the second trench structure and the third trench structure.

31. The method according to claim 30, further comprising:
forming a second doped region in the semiconductor material layer, wherein the second doped region has the second conductivity type and is located between the third gate and the first gate;
forming a third doped region in the second doped region and adjoining a portion of the first surface of the semiconductor material layer, the third doped region being heavily doped with a first conductivity type; and
forming a third conductive plug between the second doped region and the metal layer, wherein the third conductive plug extends from the metal layer, passes through the third doped region, and contacts the second doped region.

32. The method according to claim 31, wherein forming the first doped region is before forming the third doped region.

33. The method according to claim 23, wherein forming the first electrode is before forming the first gate.
